# EUROPEAN PATENT APPLICATION

(11) **EP 2 003 683 A1**
(43) Date of publication of application: **17.12.2008**
(21) Application number: 07738845.2
(22) Date of filing: 16.03.2007
(51) Int. Cl.: H01L 21/027, G03F 7/20

(54) **EXPOSURE APPARATUS AND DEVICE MANUFACTURING METHOD**

(30) Priority: 17.03.2006 JP 2006074245
(71) Applicant: Nikon Corporation, Tokyo 100-8331 (JP)
(72) Inventor: NAGASAKA, Hiroyuki, Tokyo 100-8331 (JP)
(74) Representative: Hooiveld, Arjen Jan Winfried
(86) International application number: PCT/JP2007/055400
(87) International publication number: WO 2007/108415

(57) **Abstract**

An exposure apparatus that includes a first optical system (PL) having an optical element (20) that separates incident exposure light (L1) into a first exposure light (L11) and a second exposure light (L12) and emits the first exposure light (L11) in a first direction and emits the second exposure light (L12) in a second direction that differs from the first direction; and a second optical system (HL) that irradiates the second exposure light (L12) that is emitted from the optical element (20) in the second direction onto the substrate (P) together with the first exposure light (L11) that is emitted in the first direction.

## Description

### TECHNICAL FIELD

The present invention relates to an exposure apparatus that exposes a substrate, and a device manufacturing method.

Priority is claimed on Japanese Patent Application No. 2006-074245, filed March 17, 2006, the content of which is incorporated herein by reference.

### BACKGROUND ART

In a photolithography process that is one of the processes for fabricating a microdevice such as a semiconductor device or the like, an exposure apparatus is used that exposes a substrate by irradiating exposure light onto the substrate. The following patent document discloses art related to an exposure apparatus that makes a plurality of exposure lights incident on a beam splitter and multiply exposes the substrate with the exposure lights via the beam splitter.
[Patent Document 1] Japanese Patent Application, First Publication No. 2001-297976

### DISCLOSURE OF INVENTION

### PROBLEMS TO BE SOLVED BY THE INVENTION

One performance that is desired in an exposure apparatus is the ability to favorably form various patterns on a substrate, that is, the ability to favorably cater to a diversification of patterns. However, in the case of attempting to change the illumination conditions and the like in response to a pattern, by disposing, for example, a polarization beam splitter in the optical path of the exposure light, the illumination conditions become constrained by the polarization beam splitter. As a result, there is a possibility of not being able to favorably cater to a diversification of patterns.

A purpose of the invention is to provide an exposure apparatus that can favorably cater to a diversification of patterns and can favorably form various patterns on a substrate and a device manufacturing method.

### MEANS FOR SOLVING THE PROBLEM

The present invention adopts the following configurations that correspond to the drawings, which describe the embodiments. However, any parenthesized symbol appended to an element is merely for the purpose of illustration and that element is not limited thereby.

According to a first aspect of the present invention, for example, in an exposure apparatus that exposes a substrate (P), there is provided an exposure apparatus (EX) comprising: a first optical system (PL) having an optical element (20) that separates incident exposure light (L1) into a first exposure light (L11) and a second exposure light (L12) and emits the first exposure light (L11) in a first direction and emits the second exposure light (L12) in a second direction that differs from the first direction; and a second optical system (HL) that irradiates the second exposure light (L12) that is emitted from the optical element (20) in the second direction onto the substrate (P) together with the first exposure light (L11) that is emitted in the first direction.

According to the first aspect of the present invention, it is possible to favorably form a pattern on the substrate.

According to a second aspect of the present invention, for example, in an exposure apparatus that exposes a substrate (P), there is provided an exposure apparatus (EX) comprising: a first optical system (PL) having an optical element (20) that is arranged at a position at which a plurality of exposure lights (L1, L2) can be incident, with the substrate (P) being irradiated by exposure light from the optical element (20); and capable of selecting a first mode that singly exposes a predetermined field (SH) on the substrate (P) with an image of a first pattern (PA1) that is formed on a first exposure field (AR1) by irradiating exposure light (L11, L12) on the first exposure field (AR1) via the first pattern (PA1) and the optical element (20), and a second mode that multiply exposes a predetermined field (SH) on the substrate (P) with an image of the first pattern (PA1) that is formed on the first exposure field (AR1) by irradiating exposure light (L1) on the first exposure field (AR1) via the first pattern (PA1) and the optical element (20) and with an image of a second pattern (PA2) that is formed on a second exposure field (AR2) by irradiating exposure light (L2) on the second exposure field (AR2) via the second pattern (PA2) and the optical element (20).

According to the second aspect of the present invention, it is possible to favorably form a pattern on the substrate.

According to a third aspect of the present invention, there is provided a device manufacturing method that uses the exposure apparatus (EX) of the aforementioned aspect.

According to the third aspect of the present invention, a device can be manufactured using an exposure apparatus that can favorably form a pattern on a substrate.

### EFFECTS OF THE INVENTION

According to the present invention, it is possible to favorably form a pattern on a substrate, and possible to manufacture a device having the desired performance.

### BRIEF DESCRIPTION OF THE DRAWINGS

FIG. 1 is a schematic block diagram showing an exposure apparatus in the first mode state, according to the first embodiment.
FIG. 2 is a diagram showing an example of the illumination system.
FIG. 3 is a diagram showing an example of a polarization conversion element of the illumination system.
FIG. 4 is a diagram showing an example of a secondary light source of the illumination system.
FIG. 5 is a schematic diagram showing the exposure apparatus in the first mode state, according to the first embodiment.
FIG. 6 is a schematic block diagram showing the exposure apparatus in the second mode state, according to the first embodiment.
FIG. 7 is a diagram showing an example of an aperture stop in the first illumination system.
FIG. 8 is a diagram showing an example of an aperture stop in the second illumination system.
FIG. 9 is a diagram showing a first mask which is held on a first mask stage.
FIG. 10 is a diagram showing a second mask which is held on a second mask stage.
FIG. 11 is a schematic diagram showing how exposure light from the first illumination system is incident on the first mask.
FIG. 12 is a schematic diagram showing how exposure light from the second illumination system is incident on the second mask.
FIG. 13 is a schematic diagram showing the exposure apparatus in the second mode state, according to the first embodiment.
FIG. 14 is a schematic diagram showing the relationship between the shot field on the substrate and the exposure field.
FIG. 15 is a schematic diagram showing the exposure apparatus in the first mode state, according to a second embodiment.
FIG. 16 is a flowchart that depicts one example of a process for fabricating a microdevice.

### DESCRIPTION OF THE REFERENCE SYMBOLS

1: first mask stage, 2: second mask stage, 4: substrate stage, 5: control unit, 20: optical element, 25: predetermined surface, 41: first optical system, 42: second optical system, 43: third optical system, 44: fourth optical system, AR1: first exposure field, AR2: second exposure field, EX: exposure apparatus, HL: second optical system, IL1: first illumination system, IL2: second illumination system, L1: exposure light, L11: first exposure light, L12: second exposure light, L2: exposure light, LU1: first optical unit, LU2: second optical unit, M1: first mask, M2: second mask, P: substrate, PA1: first pattern, PA2: second pattern, PL: first optical system, SH: shot field

### BEST MODE FOR CARRYING OUT THE INVENTION

Hereunder is a description of embodiments of the present invention, with reference to the drawings. However, the present invention is not limited to this description. In the following description, an XYZ rectangular co-ordinate system is established, and the positional relationship of respective members is described with reference to this XYZ rectangular co-ordinate system. A predetermined direction within a horizontal plane is made the X-axis direction, a direction orthogonal to the X-axis direction in the horizontal plane is made the Y-axis direction, and a direction orthogonal to both the X-axis direction and the Y-axis direction (that is, a perpendicular direction) is made the Z-axis direction. Furthermore, rotation (inclination) directions about the X axis, the Y axis and the Z axis, are made the θX, the θY, and the θZ directions, respectively.

### <First Embodiment>

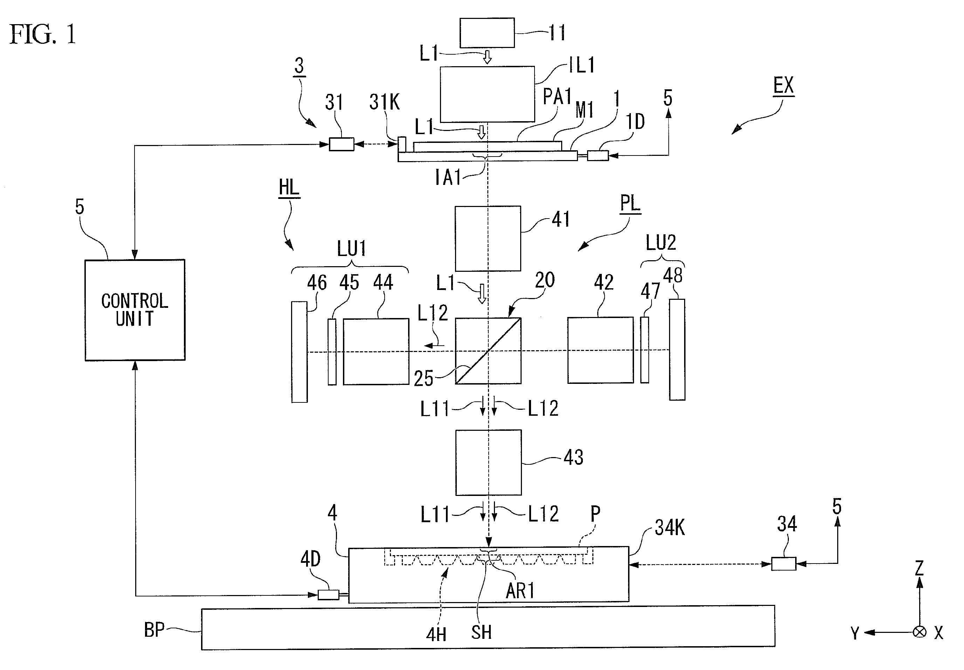

A first embodiment will be described. FIG. 1 is a schematic block diagram showing an exposure apparatus EX according to the first embodiment. In FIG. 1, the exposure apparatus EX includes a first optical system PL having an optical element 20 that separates incident exposure light L1 into a first exposure light L11 and a second exposure light L12 and emits the first exposure light L11 in a first direction and emits the second exposure light L12 in a second direction that differs from the first direction; and a second optical system HL that irradiates the second exposure light L12 that is emitted from the optical element 20 in the second direction onto the substrate P together with the first exposure light L11 that is emitted in the first direction. In the present embodiment, the optical element 20 separates the incident exposure light L1 into the first exposure light L11 and the second exposure light L12 and emits the first exposure light L11 in a -Z direction towards the substrate P and emits the second exposure light L12 in a +Y direction not towards the substrate P, that is, in a direction that is different to the direction towards the substrate P.

Furthermore, the exposure apparatus EX shown in FIG. 1 is provided with a first mask stage 1 that is capable of holding and moving a first mask M1 having a first pattern PA1, a substrate stage 4 that is capable of holding and moving the substrate P, a measurement system 3 that is capable of measuring position information of the respective stages, a first illumination system IL1 that illuminates the first pattern PA1 of the first mask M1 with the exposure light L1, and a control unit 5 that controls the operation of the overall exposure apparatus EX.

The first optical system PL projects an image of the first pattern PA1 illuminated by the exposure light L1 onto the substrate P. The exposure light L1 from the first pattern PA1 is incident on the optical element 20. Furthermore, the first optical system PL sets a first exposure field AR1 adjacent to the light emission side of the first optical system PL, that is, the image surface side of the first optical system PL. The first optical system PL, by irradiating the exposure lights L11 and L12 from the optical element 20 onto the first exposure field AR1, is capable of forming an image of the first pattern PA1 on the first exposure field AR1. Furthermore, the substrate P is arranged adjacent to the light emission side (image surface side) of the first optical system PL. The first optical system PL is capable of irradiating the exposure lights L11, L12 onto the substrate P. The exposure apparatus EX forms (projects) an image of the first pattern PA1 onto the first exposure field AR1 by means of the exposure light L1 (L11, L12) emitted from the first illumination system IL1 and irradiated onto the first exposure field AR1 via the first pattern PA1 and the first optical system PL, and exposes a shot field SH on the substrate P with the image of the first pattern PA1.

Substrate here includes one in which a photosensitive material (photoresist) is coated on a substrate such as a semiconductor wafer such as a silicon wafer and includes one in which various films such as a protective film (topcoat film) separate from the photosensitive film are coated. The mask includes a reticle on which is formed a device pattern to be projected in a reduced size onto the substrate, and includes one where a predetermined pattern is formed using a light shielding membrane such as chrome or the like on a transparent member such as a glass plate. This transmission-type mask is not limited to a binary mask on which a pattern is formed with a shading film, and also includes, for example, a phase-shift mask such as a half-tone type or a spatial frequency modulation type. Furthermore, in the present embodiment, a transmission-type mask is used for the mask, however a reflection-type mask can be used.

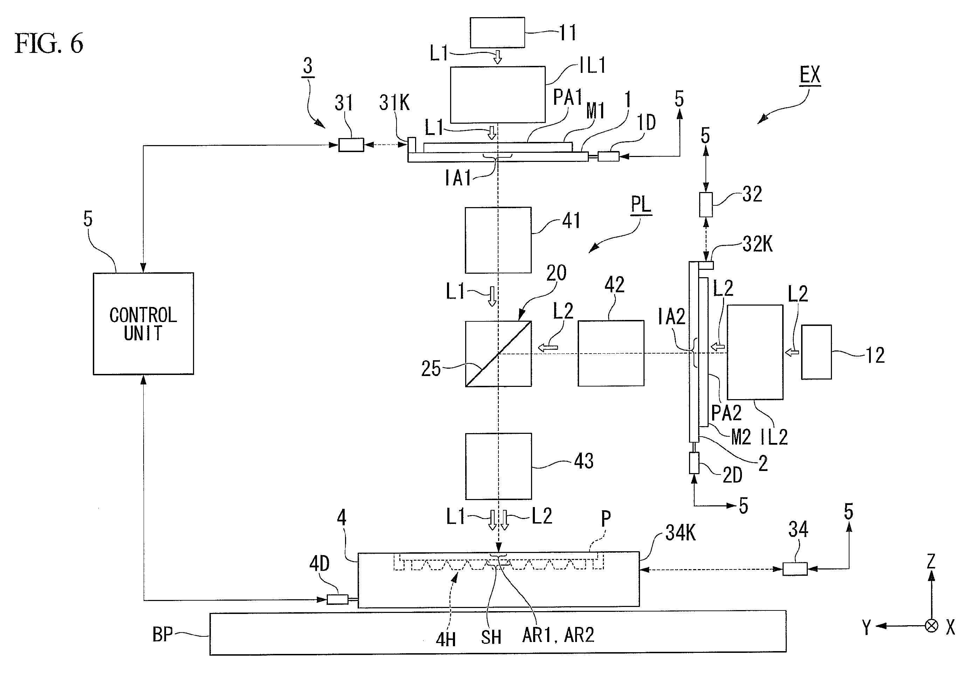

Furthermore, as described below, the second optical system HL is attachable and detachable to or from the first optical system PL. The exposure apparatus EX of the present embodiment is capable of selecting a first mode and a second mode. In the first mode, the second optical system HL is arranged at a predetermined position with respect to the first optical system PL and the exposure light L1 from the first optical system PL is made incident on the optical element 20 to singly expose (normally expose) the shot field SH on the substrate P with an image of the first pattern PA1. In the second mode, the second optical system HL is removed from the first optical system PL, and the exposure light L1 from the first pattern PA1 and an exposure light L2 from a second pattern PA2 are each made incident on the optical element 20 to multiply expose (double expose) a shot field SH on the substrate P with an image of the first pattern PA1 and an image of the second pattern PA2. FIG. 1 shows the exposure apparatus EX in the first mode state. FIG. 6 shows the exposure apparatus EX in the second mode state.

The exposure apparatus EX in the state of being selected to the first mode shall be described with reference to FIG. 1 to FIG. 5.

At first is a description of the first illumination system IL1. The first illumination system IL1 illuminates a first illumination field IA1 on a first mask M1 held in the first mask stage 1 with the exposure light L1 of a uniform luminance distribution. The exposure apparatus EX has a first light source device 11 corresponding to the first illumination system IL1. For the exposure light L1 emitted from the first illumination system IL1, for example emission lines (g-ray, h-ray, i-ray), emitted for example from a mercury lamp, deep ultraviolet beams (DUV light beams) such as the KrF excimer laser beam (wavelength: 248nm), and vacuum ultraviolet light beams (VUV light beams) such as the ArF excimer laser beam (wavelength: 193nm) and the F₂ laser beam (wavelength: 157nm), can be used. In this embodiment, an ArF excimer laser apparatus is used as the first light source device 11, and the ArF excimer laser beam is used for the exposure light L1.

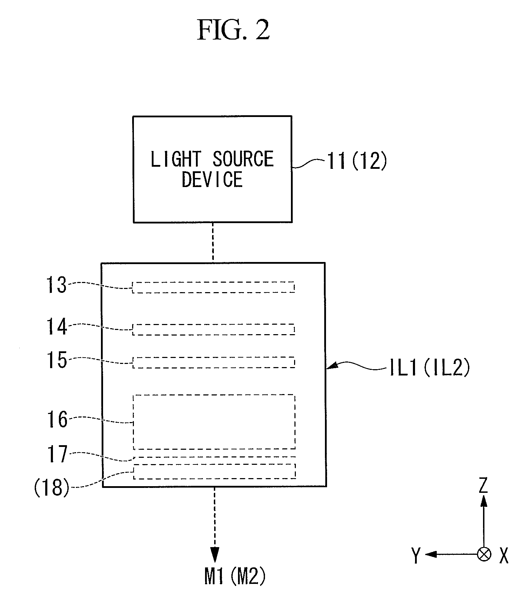

FIG. 2 is a schematic diagram showing an example of the first illumination system IL1 according to the present embodiment. The first illumination system IL1 of the present embodiment includes a beam expander, a polarization switching optical system 13, a diffractive-optical element 14, an afocal optical system (non-focal optical system), a zoom optical system, a polarization conversion element 15, and an optical integrator 16 and the like, as disclosed in PCT International Publication No. WO 2005/076045. Furthermore, as required, an aperture stop 18 is provided near the light-emitting face of the optical integrator 16. Furthermore, although not illustrated, the first illumination system IL1 is also provided with a blind device that sets the first illumination field IA1 of the exposure light L1 on the first mask M1, and a condenser optical system.

The polarization switching optical system 13 can switch the exposure light L1 that is incident on the diffractive-optical element 14 between a polarization state and non-polarization state. Furthermore, the polarization switching optical system 13 can switch the exposure light L1 between a linear polarization state and a circular polarization state when in the polarization state. Furthermore, the polarization switching optical system 13 can switch the exposure light L1 between polarization states that are mutually perpendicular (between S polarized light and P polarized light) when in the linear polarization state.

The diffractive-optical element 14 has a function of diffracting the incident exposure light L1 at a desired angle. The diffractive-optical element 14 generates diffracted light by the exposure light L1 from the first light source device 11, and is capable of illuminating a predetermined face in a predetermined illumination field with the diffracted light. The diffractive-optical element 14 has a level difference (uneven structure) of a pitch on the scale of the wavelength of the exposure light L1 formed on a predetermined material. Structural conditions including the pitch, depth of the concave portions of the uneven structure (height of the convex portions), and directions in which the internal surfaces of the concave portions (outer surfaces of the convex portions) face are suitably adjusted. Thereby, the size and shape of the illumination field can be set by this diffractive-optical element 14. For example, the diffractive-optical element 14 generates diffracted light by the exposure light L1 from the first light source device 11. With this diffracted light that is generated, the light incident face of the optical integrator 16 that includes a micro fly-eye lens can be illuminated by an illumination field having a predetermined size and shape via the afocal optical system, the zoom optical system and the polarization conversion element 15 and the like. In the present embodiment, a ring-shaped illumination field centered on the optical axis of the first illumination system IL1 is formed on the light incident face of the optical integrator 16. A ring-shaped secondary light source 17 centered on the optical axis of the first illumination system IL1 is formed adjacent to the light-emitting face (rear side focal plane) of the optical integrator 16. Furthermore, by adjusting the focal length of the zoom optical system, the control unit 5 can adjust the size and shape of the illumination field in the light incident face of the optical integrator 16 and in turn the size and shape of the secondary light source 17.

The polarization conversion element 15 converts the polarization state of the exposure light L1. In the present embodiment, the polarization conversion element 15 is disposed immediately before (near the light incident face of) the optical integrator 16. The polarization conversion element 15 can adjust the polarization state of the exposure light L 1 that enters the light incident face of the optical integrator 16 (and in turn the polarization state of the exposure light L1 that is irradiated on the first mask M1 and the substrate P).

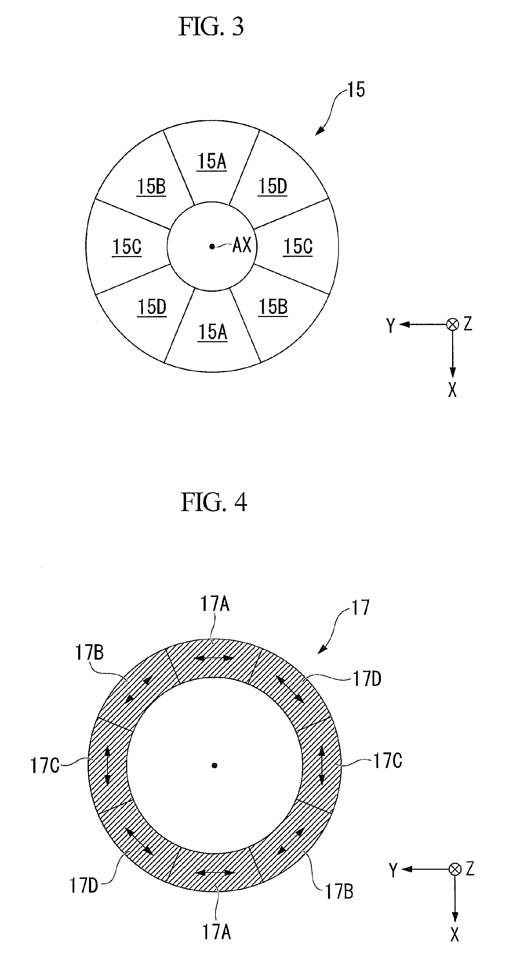

FIG. 3 is a diagram showing an example of the polarization conversion element 15. The polarization conversion element 15 has a ring-shaped effective area centered on the optical axis AX of the first illumination system IL1. The ring-shaped effective area is formed by an optical material having optical rotation, such as quartz. The optical material of the effective area that is formed in a ring shape has a distribution of thickness that changes in relation to the circumferential direction. Here, thickness of the optical material means the length in relation to the light transmission direction of the optical material (Y-axis direction).

In the present embodiment, the polarization conversion element 15 has a plurality of fundamental elements 15A to 15D that are disposed in the ring-shaped effective area and consist of an optical material having optical activity. In the present embodiment, the polarization conversion element 15 is provided with two each of the first to fourth fundamental elements 15A to 15D having mutually different characteristics, and therefore provided with a total of eight fundamental elements 15A to 15D. The first to fourth fundamental elements 15A to 15D are formed in a fan shape in the XY direction in FIG. 3, with the ring-shaped effective area being disposed so as to be divided into nearly equal parts. Furthermore, the two each of the fundamental elements 15A, 15B, 15C, and 15D having the same characteristics are arranged so as to be sandwiching the optical axis AX and facing each other. Furthermore, the first to fourth fundamental elements 15A to 15D are disposed so that the crystal optical axis and the optical axis AX become substantially parallel, that is, the crystal optical axis and the direction of travel of incident light substantially agree.

As described above, in the present embodiment, a ring-shaped illumination field is formed by the exposure light L1 centered on the optical axis AX in the light incident face of the optical integrator 16. That is, the exposure light L1 having a ring-shaped cross section substantially centered on the optical axis AX is set so as to be incident on the light incident face of the optical integrator 16. Accordingly, the exposure light L1 that has a mostly ring-shaped cross section centered on the optical axis AX is incident on the ring-shaped effective region of the polarization conversion element 15 that is provided directly before the optical integrator 16.

The exposure light L1 that is incident on the first to fourth fundamental elements 15A to 15D that are disposed in the ring-shaped effective region of the polarization conversion element 15 undergoes a change of polarization state due to the optical rotation of the fundamental elements 15A to 15D and is emitted by the fundamental elements 15A to 15D. For example, in the case of exposure light L1 having linearly polarized light of a predetermined direction as a main component being incident on the fundamental elements 15A to 15D, each of the fundamental elements 15A to 15D of the polarization conversion element 15 converts the polarization state of the exposure light L1 so as to rotate the polarization direction of the incident exposure light L1 by a predetermined rotation angle about optical axis AX (direction θZ in the diagram), and emits the exposure light L1 with a converted polarization state. The rotation angle of the polarization direction is defined in accordance with the optical rotation and thickness etc. of each of the fundamental elements 15A to 15D. By setting the optical rotation and thickness etc. of each of the fundamental elements 15A to 15D, the polarization conversion element 15 rotates the polarization direction of the exposure light L1, which is incident in a linearly polarized state, by a predetermined rotation angle and emits the exposure light L1 in a polarization state in which the polarization direction has been changed.

In the present embodiment, the thicknesses of the first to fourth fundamental elements 15A to 15D in relation to the light transmission direction (Z-axis direction) differ from each other. Each of the fundamental elements 15A to 15D thus rotates the polarization direction of the incident exposure light L1 by mutually different rotation angles. The exposure light L1 of which the polarization state (polarization direction) has been converted by the fundamental elements 15A to 15D is incident on the optical integrator 16 from the light incident face of the optical integrator 16, and forms the ring-shaped secondary light source 17 that is centered on the optical axis AX on the light-emitting face of the optical integrator 16.

FIG. 4 is a diagram schematically showing the secondary light source 17 that is formed on the light-emitting face of the optical integrator 16 by the exposure light L1 having passed through the polarization conversion element 15 and the optical integrator 16. In the present embodiment, the exposure light L1 having linear polarization in the X-axis direction as the main component is incident on the first to fourth fundamental elements 15A to 15D in FIG. 3 and FIG. 4.

In FIG. 3 and FIG. 4, the first fundamental element 15A is set so as to rotate the polarization direction of the incident exposure light L1 by +90° in the θZ direction with respect to the X axis. Accordingly, exposure light L1 in a linearly polarized state in which its polarization direction is made a direction rotated +90° in the θZ direction with respect to the X axis is emitted from the first fundamental element 15A. Furthermore, in the secondary light source 17, exposure light L1 in a linearly polarized state in which its polarization direction is made a direction rotated +90° in the θZ direction with respect to the X axis is emitted from a first circular region 17A that is formed by the exposure light L1 subjected to the rotatory polarization action of the first fundamental element 15A.

The second fundamental element 15B is set so as to rotate the polarization direction of the incident exposure light L1 by +135° in the θZ direction. Accordingly, exposure light L1 in a linearly polarized state in which its polarization direction is made a direction rotated +135° in the θZ direction with respect to the X axis is emitted from the second fundamental element 15B. Furthermore, in the secondary light source 17, exposure light L1 in a linearly polarized state in which its polarization direction is made a direction rotated +135° in the θZ direction with respect to the X axis is emitted from a second circular region 17B that is formed by the exposure light L1 subjected to the rotatory polarization action of the second fundamental element 15B.

The third fundamental element 15C is set so as to rotate the polarization direction of the incident exposure light L1 by +180° in the θZ direction. Accordingly, exposure light L1 in a linearly polarized state in which its polarization direction is made a direction parallel to the X axis is emitted from the third fundamental element 15C. Furthermore, in the secondary light source 17, exposure light L1 in a linearly polarized state in which its polarization direction is made a direction parallel to the X axis is emitted from a third circular region 17C that is formed by the exposure light L1 subjected to the rotatory polarization action of the third fundamental element 15C.

The fourth fundamental element 15D is set so as to rotate the polarization direction of the incident exposure light L1 by +45° in the θZ direction. Accordingly, exposure light L1 in a linearly polarized state in which its polarization direction is made a direction rotated +45° in the θZ direction with respect to the X axis is emitted from the fourth fundamental element 15D. Furthermore, in the secondary light source 17, exposure light L1 in a linearly polarized state in which its polarization direction is made a direction rotated +45° in the θZ direction with respect to the X axis is emitted from a fourth circular region 17D that is formed by the exposure light L1 subjected to the rotatory polarization action of the fourth fundamental element 15D.

In this way, in the present embodiment, the polarization conversion element 15 converts the exposure light L1 in a linearly polarized state in which a mostly single direction serves as the polarization direction into exposure light L1 in a linearly polarized state in which the circumferential direction of the polarization conversion element 15 serves as the polarization direction. In the following description, the linearly polarized state in which the circumferential direction of the polarization conversion element 15 serves as the polarization direction is for convenience referred to as the circumferential polarization state.

Thereby, the exposure light L1 that is emitted from the ring-shaped secondary light source 17 that is formed on the light-emitting face of the optical integrator 16 will be in the circumferential polarization state.

The exposure light L1 from the secondary light source 17 that is formed on the light-emitting face of the optical integrator 16 is incident on the condenser optical system not illustrated. The secondary light source 17 illuminates the blind device in a superposing manner via the condenser optical system. The exposure light L1 that has passed through the optical transmission region of the blind device is irradiated on the first mask M1.

In the first mode state, the aperture stop 18 is not disposed near the light-emitting face of the optical integrator 16, that is, immediately after the secondary light source 17. Accordingly, the first mask M1 is illuminated by the exposure light L1 in the circumferential polarization state. The exposure light L1 in the circumferential polarization state includes a linear polarized light component that has the direction parallel to the X axis as its polarization direction (P polarized light component) and a linear polarized light component that has the direction parallel to the Y axis as its polarization direction (S polarized light component).

Here, S polarized light (transverse-electric (TE) polarization) is linear polarized light that has a polarization direction in a direction perpendicular to the plane of incidence (polarization in which the electric vector oscillates in a direction perpendicular to the plane of incidence). The plane of incidence is defined as a plane including the normal of the boundary and the incidence direction of the light at the point when the light reaches the boundary of the medium (irradiated surface: at least one of the surface of the mask and the surface of the substrate). P polarized light (transverse-magnetic (TM) polarized light) is linear polarized light that has a polarization direction in a direction parallel to the plane of incidence that is defined as mentioned above (polarization in which the electric vector oscillates in a direction parallel to the plane of incidence.)

Next is a description of the first mask stage 1 referring to FIG. 1. The first mask stage 1 is movable by driving of a first mask stage drive device 1D, which includes an actuator such as a linear motor, in the X axis, the Y axis, and the θZ directions in a state of holding the first mask M1. The first mask stage 1 holds the first mask M1 so that a first pattern forming surface on which a first pattern PA1 of the first mask M1 is formed is substantially parallel with the XY plane. Position information of the first mask stage 1 (and in turn the first mask M1) is measured by a laser interferometer 31 of the measurement system 3. The laser interferometer 31 measures the position information of the first mask stage 1 using a reflecting surface 31 K of a moving mirror provided on the first mask stage 1. The control unit 5 drives the first mask stage drive device 1D based on the measurement result of the laser interferometer 31, to perform position control of the first mask M1 which is held on the first mask stage 1.

The first mask stage 1 is capable of moving the first mask M1 having the first pattern PA1 in the Y-axis direction with respect to the exposure light L1. The control unit 5, when exposing the shot field SH on the substrate P, controls the first mask stage 1 so that a first pattern forming field of the first mask M1 in which is formed at least the first pattern PA1 passes through the first illumination field IA1 due to the exposure light L1, and thereby moves the first mask M1 in the Y-axis direction.

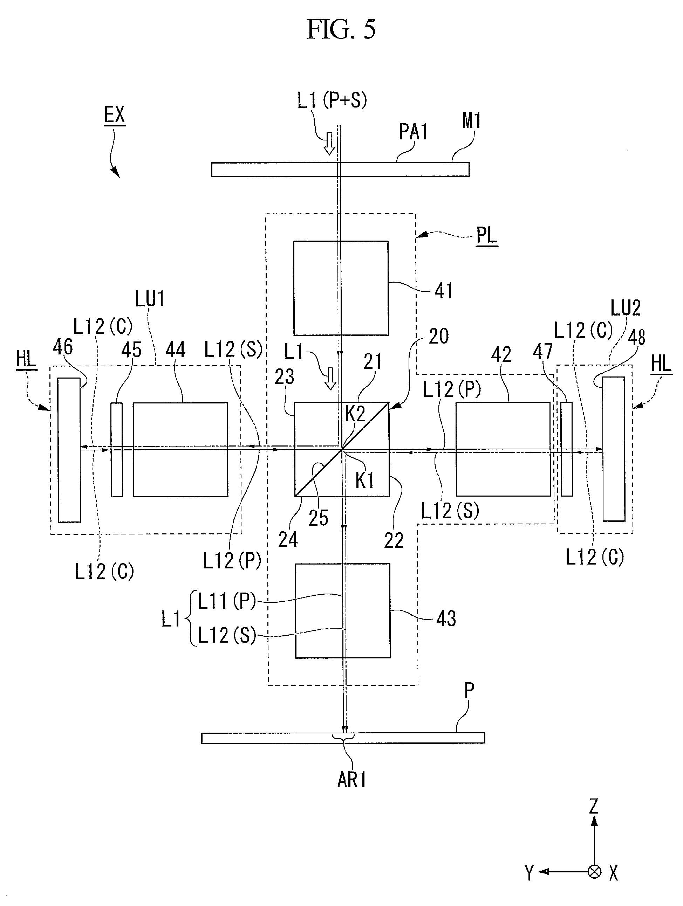

Next is a description of the first optical system PL and the second optical system HL with reference to FIG. 5. The first optical system PL projects an image of the first pattern PA1 of the first mask M1, which is illuminated by the exposure light L1, onto the substrate P at a predetermined projection magnification. The first optical system PL in the present embodiment is a reduction system of, for example, 1/4, 1/5, or 1/8.

As described above, the first optical system PL has the optical element 20 that separates the incident exposure light L1 into the first exposure light L11 and the second exposure light L12 and emits the first exposure light L11 in the -Z direction towards the substrate P and emits the second exposure light L12 in the +Y direction not towards the substrate P. The exposure light L1 from the first pattern PA1 is incident on the exposure element 20. Furthermore, the second optical system HL processes the second exposure light L12, which is emitted from the optical element 20 in the +Y direction, so that the second exposure light L12, which is emitted from the optical element 20 in the +Y direction, is emitted in the -Z direction via the optical element 20, and thereafter makes it incident on the optical element 20. The first optical system PL irradiates the first and second exposure lights L11 and L12 from the optical element 20 on the first exposure field AR1 of the substrate. The first optical system PL forms (projects) the image of the first pattern PA1 on the first exposure field AR1 based on the first and second exposure lights L11 and L12 irradiated on the first exposure field AR1 via the first pattern PA1 and the optical element 20.

The first optical system PL includes a first optical system 41 that guides the exposure light L1 from the first pattern PA1 to the optical element 20, a second optical system 42 that is disposed at a predetermined position with respect to the optical element 20, and a third optical system 43 the guides the first and second exposure lights L11 and L12 from the optical element 20 to the first exposure field AR1.

The optical element 20 has a first surface 21 that, in the diagram, faces the +Z direction, a second surface 22 that faces the -Y direction, a third surface 23 that faces the +Y direction, and a fourth surface 24 that faces the -Z direction. The first surface 21 faces the first optical system 41, and the exposure light L1 from the first pattern PA1 of the first mask M1 is incident on the first surface 21 via the first optical system 41. The second surface 22 faces the second optical system 42. The fourth surface 24 faces the third optical system 43. The exposure light emitted from the fourth surface 24 is irradiated on the substrate P via the third optical system 43.

The optical element 20 has a predetermined surface 25 that passes a portion of the incident exposure light L1 to be emitted in the -Z direction and reflects the remaining portion of the incident exposure light L1 to be emitted in the +Y direction. The optical element 20 of the present embodiment is a polarization separation optical element (polarization beam splitter) in which the predetermined surface 25 is a polarization separation surface that separates the incident exposure light L1 into the first exposure light L11 of a first polarization state and the second exposure light L12 of a second polarization state. That is, the optical element 20 of the present embodiment separates the incident exposure light L1 into the first exposure light L11 having a first polarization component as its main component and the second exposure light L12 having a second polarization component as its main component. In the present embodiment, the predetermined surface (polarization separation surface) 25 of the optical element 20 passes the first exposure light L11 of the first polarization state that is a portion of the incident exposure light L1 and reflects the second exposure light L12 of the second polarization state that is the remaining portion. The first exposure light L11 of the first polarization state, after passing through the predetermined surface 25, is emitted by the optical element 20 in the -Z direction via the fourth surface 24. The second exposure light L12 of the second polarization state, after being reflected by the predetermined surface 25, is emitted by the optical element 20 in the +Y direction via the third surface 23.

Among the incident exposure light L1, the predetermined surface (polarization separation surface) 25 of the optical element 20 passes the exposure light having a P-polarization component as the main component and reflects exposure light having an S-polarization component as the main component. That is, in the present embodiment, the first exposure light L11 is exposure light having a P-polarization component as the main component, and the second exposure light L12 is exposure light having an S-polarization component as the main component. In the present embodiment, the exposure light L1 from the first pattern PA1 that is incident on the optical element 20 is exposure light of the circumferential polarization state, and includes at least a P-polarization component and an S-polarization component. The optical element 20 is capable of separating the incident exposure light L1 into the first exposure light L11 having a P-polarization component as its main component and the second exposure light L12 having an S-polarization component as its main component.

In the present embodiment, among the exposure light L1 from the first pattern PA1 that is incident on the optical element 20 via the first surface 21, the first exposure light EL1 having a P-polarization component as its main component passes through the predetermined surface (polarization separation surface) 25 to be emitted in the -Z direction from the fourth surface 24 of the optical element 20. The second exposure light L12 having an S-polarization component as its main component is reflected by the predetermined surface (polarization separation surface) 25 to be emitted in the +Y direction from the third surface 23 of the optical element 20.

The second optical system HL irradiates the second exposure light L12 that is emitted from the optical element 20 in the +Y direction not towards the substrate P onto the substrate P together with the first exposure light L11 that is emitted in the -Z direction, and processes the second exposure light L12 so that the second exposure light L12, which is separated with the first exposure light L11 by the predetermined surface (polarization separation surface) 25 of the optical element 20, is irradiated onto the substrate P.

In the present embodiment, the second optical system HL processes the second exposure light L12 that is emitted from the optical element 20 in the +Y direction so that the second exposure light L12, which is emitted from the optical element 20 in the +Y direction, is emitted in the -Z direction via the optical element 20 and then makes the second exposure light L12 incident on the optical element 20.

The second optical system HL includes a first optical unit LU1 and a second optical unit LU2 that process the second exposure light L12 that is emitted from the optical element 20 in the +Y direction not towards the substrate P to direct it towards the substrate P. In the present embodiment, the first optical unit LU1 is arranged lateral to the +Y side of the optical element 20, while the second optical unit LU2 is arranged lateral to the -Y side of the optical element 20.

The second optical system HL that includes the first optical unit LU1 and the second optical unit LU2 adjusts the transmission/reflection characteristics with respect to the predetermined surface 25 of the second exposure light L12 that is emitted from the optical element 20 in the +Y direction not towards the substrate P, and then by making the second exposure light L12 incident again on the predetermined surface 25, the second exposure light L12 is directed towards the substrate P. In the present embodiment, the second optical system HL converts the polarization state of the second exposure light L12 that emitted in the +Y direction not towards the substrate P by being separated by the predetermined surface 25, and afterward by making the second exposure light L12 incident again on the predetermined surface 25, the second exposure light L12 is directed towards the substrate P.

The second exposure light L12, which is incident on the optical element 20 via the first surface 21 from the first pattern PA1 and reflected by the predetermined surface 25, is emitted from the third surface 23 in the +Y direction and made incident on the first optical unit LU1.

The first optical unit LU1 performs processing that reverses the transmission/reflection characteristics of the second exposure light L12 with respect to the predetermined surface 25. In the present embodiment, the first optical unit LU1 processes the second exposure light L12, which has been reflected by the predetermined surface 25 of the optical element 20 to be emitted from the optical element 20 in the +Y direction, so as to pass through the predetermined surface 25, and then makes the second exposure light L12 incident on the predetermined surface 25.

Specifically, the first optical unit LU1 makes the second exposure light L12 incident on the predetermined surface 25 by converting the polarization state of the second exposure light L12 in the S-polarization state emitted from the optical element 20 in the +Y direction to the P-polarization state.

The first optical unit LU1 is arranged outside of the optical element 20 and includes a fourth optical system 44 that is disposed at a position facing the third surface 23 of the optical element 20, a reflecting member (reflecting mirror) that has a first reflecting surface 46 that guides the second exposure light L12, which has been emitted from the optical element 20 in the +Y direction via the third surface 23, so as to be made incident again on the optical element 20, and a polarization conversion element 45 that converts the polarization state of the second exposure light L12. The polarization conversion element 45 includes a λ/4-wavelength plate. The first reflection surface 46 faces the optical element 20 (-Y direction), and the polarization conversion element 45 is arranged between the optical element 20 and the first reflecting surface 46, specifically, between the fourth optical system 44 and the first reflecting surface 46 that are arranged lateral to the +Y side of the optical element 20.

The second exposure light L12 in the S-polarization state that has been emitted from the optical element 20 in the +Y direction via the third surface 23 is incident on the fourth optical system 44. The second exposure light L12 in the S-polarization state that is incident on the fourth optical system 44 and passes through the fourth optical system 44 is incident on the polarization conversion element 45. As mentioned above, the polarization conversion element 45 includes a λ/4-wavelength plate, and so the second exposure light L12 in the S-polarization state is converted to the circular polarization state by passing through the polarization conversion element 45.

In FIG. 5, the second exposure light L12 in the S-polarization state is denoted as L12(S), the second exposure light L12 in the P-polarization state is denoted as L12(P), and the second exposure light L12 in the circular polarization state is denoted as L12(C). Furthermore, the first exposure light L11 in the P-polarization state is denoted as L11(P).

The second exposure light L12 that has been converted to the circular polarization state by passing through the polarization conversion element 45 is incident on the first reflecting surface 46 and reflected by the first reflecting surface 46. The second exposure light L12 in the circular polarization state that has been reflected by the first reflecting surface 46 is incident again on the polarization conversion element 45. As mentioned above, the polarization conversion element 45 includes a λ/4-wavelength plate, and so the second exposure light L12 in the circular polarization state, by passing through the polarization conversion element 45, is converted to the P-polarization state. The second exposure light L12, which has been converted to the P-polarization state by passing through the polarization conversion element 45, is incident on the fourth optical system 44, and after passing through the fourth optical system 44, is incident on the optical element 20 via the third surface 23. Because the second exposure light L12 that is incident on the optical element 20 via the third surface 23 is exposure light in the P-polarization state, it can pass through the predetermined surface 25 of the optical element 20. Accordingly, the second exposure light L12 in the P-polarization state that is incident on the optical element 20 via the third surface 23, after passing through the predetermined surface 25 of the optical element 20, is emitted in the -Y direction via the second surface 22.

In this way, the first optical unit LU1 includes the polarization conversion element 45 that converts the polarization state of the second exposure light L12. Therefore, the first optical unit LU1, so as to pass the second exposure light L12, which is emitted in the +Y direction from the optical element 20 by being reflected by the predetermined surface 25, through the predetermined surface 25, converts the polarization state of the second exposure light L12 and then makes it incident on the predetermined surface 25.

The second exposure light L12, which is incident on the optical element 20 from the first optical unit LU1 via the third surface 23 and has passed through the predetermined surface 25, is emitted in the -Y direction from the second surface 22 to be incident on the second optical unit LU2.

The second optical unit LU2 performs processing that reverses the transmission/reflection characteristics of the second exposure light L12 with respect to the predetermined surface 25. In the present embodiment, the second optical unit LU2 processes the second exposure light L12, which has been made incident on the predetermined surface 25 of the optical element 20 from the first optical unit LU1 and has passed through the predetermined surface 25, so as to reflect it by the predetermined surface 25, and then makes the second exposure light L12 incident on the predetermined surface 25.

Specifically, the second optical unit LU2 converts to the S-polarization state the polarization state of the second exposure light L12 of the P-polarization state, which, after being converted to the P-polarization state by the first optical unit LU1, passes through the predetermined surface 25 by being incident on the predetermined surface 25 and is emitted from the optical element 20 in the -Y direction, and makes the second exposure light L12 of the S-polarization state incident on the predetermined surface 25.

Here, a position K1 at which the second exposure light L12 is made incident on the predetermined surface (polarization separation surface) 25 from the second optical unit LU2 is a position (or in the vicinity thereof) that is optically conjugate with a position K2 at which the exposure light L1 from the first pattern PA1 is made incident on the predetermined surface (polarization separation surface) 25. In FIG. 5, in order to facilitate visualization, the position K1 and the position K2 are shown shifted with respect to the predetermined surface 25.

The second optical unit LU2 has a reflecting member (reflecting mirror) that has a second reflecting surface 48 and a polarization conversion element 47 that converts the polarization state of the second exposure light L12. The second reflecting surface 48 leads the second exposure light L12, which has been emitted from the optical element 20 in the -Y direction via the second surface 22 and has passed through the second optical system 42, so as to be made incident again on the optical element 20. The polarization conversion element 47 includes a λ/4-wavelength plate. The second reflection surface 48 faces the optical element 20 (+Y direction), and the polarization conversion element 47 is arranged between the optical element 20 and the second reflecting surface 48, specifically, between the second optical system 42 and the second reflecting surface 48 that are arranged lateral to the -Y side of the optical element 20.

The second exposure light L12 in the P-polarization state, which has passed through the predetermined surface 25 of the optical element 20 and been emitted in the -Y direction from the optical element 20 via the second surface 22, is incident on the second optical system 42. The second exposure light L12 in the P-polarization state that is incident on the second optical system 42 and passes through the second optical system 42 is incident on the polarization conversion element 47. As mentioned above, the polarization conversion element 47 includes a λ/4-wavelength plate, and so the second exposure light L12 in the P-polarization state is converted to a circular polarization state by passing through the polarization conversion element 47.

The second exposure light L12 that has changed to the circular polarization state by passing through the polarization conversion element 47 is incident on the second reflecting surface 48 and reflected by the second reflecting surface 48. The second exposure light L12 in the circular polarization state that has been reflected by the second reflecting surface 48 is incident again on the polarization conversion element 47. As mentioned above, the polarization conversion element 47 includes a λ/4-wavelength plate, and so the second exposure light L12 in the circular polarization state, by passing through the polarization conversion element 47, is converted to the S-polarization state. The second exposure light L12, which has been converted to the S-polarization state by passing through the polarization conversion element 47, is incident on the second optical system 42, and after passing through the second optical system 42, is incident on the optical element 20 via the second surface 22. Because the second exposure light L12 that is incident on the optical element 20 via the second surface 22 is exposure light in the S-polarization state, it can be reflected by the predetermined surface 25 of the optical element 20. Accordingly, the second exposure light L12 in the S-polarization state that is incident on the optical element 20 via the second surface 22 from the second optical unit LU2, after being reflected by the predetermined surface 25 of the optical element 20, is emitted in the -Z direction toward the substrate P via the fourth surface 24. The optical element 20 emits in the -Z direction via the fourth surface 24 the second exposure light L12 that is made incident by being converted to the S-polarization state by the second optical unit LU2.

In this way, the second optical unit LU2 includes the polarization conversion element 47 that converts the polarization state of the second exposure light L12. Therefore, after converting the polarization state of the second exposure light L12, which is made incident on the predetermined surface 25 from the first optical unit LU1, passed through the predetermined surface 25, and emitted in the -Y direction from the optical element 20, so as to be reflected by the predetermined surface 25, it is made incident on the predetermined surface 25.

The second optical system HL, which includes the first optical unit LU1 and the second optical unit LU2, adjusts the transmission/reflection characteristics with respect to the predetermined surface 25 of the second exposure light L12 that is emitted from the optical element 20 in the +Y direction not towards the substrate P, and then by making the second exposure light L12 incident again on the predetermined surface 25, can irradiate the second exposure light L12 towards the substrate P together with the first exposure light L11. The first exposure light L11 in the P-polarization state and the second exposure light L12 in the S-polarization state that are emitted from the fourth surface 24 of the optical element 20 are irradiated onto the first exposure field AR1 that is set on the substrate P via the third optical system 43 of the first optical system PL.

Note that the first and second reflecting surfaces 46 and 48 can be flat surfaces, and can also be curved surfaces. In the case of the reflecting member that has the first and second reflecting surfaces 46 and 48 being a concave mirror, that is, in the case of the first and second reflecting surfaces 46 and 48 being concave surfaces, it is possible to minimize the Petzval sum of the optical system from the position K2 to the position K1, and thus possible to suppress field curvature. It is also possible to reduce the size of the second optical system HL.

Next, the substrate stage 4 shall be described referring to FIG. 1. The substrate stage 4 is capable of moving on a base member BP at the light emission side of the first optical system PL, that is, the image surface side of the first optical system PL. The substrate stage 4 is capable of holding and moving the substrate P within a predetermined field including the first exposure field AR1 that is irradiated by the first and second exposure lights L11 and L12. As shown in FIG. 1, the substrate stage 4 has a substrate holder 4H that holds the substrate P. The substrate holder 4H holds the substrate P so that the surface of the substrate P and the XY plane are substantially parallel. The substrate stage 4 is movable by driving of a substrate stage drive device 4D including an actuator such as a linear motor, in directions of 6 degrees of freedom of the X axis, the Y axis, the Z axis, the θX, the θY, and the θZ directions, on the base member BP in the state of the substrate P held on the substrate holder 4H.

The position information of the substrate stage 4 (and in turn the substrate P) is measured by a laser interferometer 34 of the measurement system 3. The laser interferometer 34 measures the position information related to the X axis, the Y axis, and the θZ directions of the substrate stage 4 using a reflecting surface 34K which is provided on the substrate stage 4. Furthermore, the surface information (position information related to the Z axis, the θX, and the θY directions) of the surface of the substrate P held on the substrate stage 4 is detected by a focus leveling detection system (not shown in the figure). The control unit 5 drives the substrate stage drive device 4D based on the measurement result of the laser interferometer 34 and the detection result of the focus leveling detection system, and performs position control of the substrate P held in the substrate stage 4.

The focus leveling detection system measures the position information of the substrate in the Z-axis direction at a plurality of measurement points respectively to thereby detect the surface position information of the substrate, as disclosed for example in U.S. Patent No. 6,608,681. At least some of the plurality of measurement points can be set within the exposure field, and all of the measurement points can be set outside the exposure field. Furthermore, the laser interferometer can be able to measure position information of the substrate stage in the Z axis, the θX and the θY directions. This is disclosed in detail for example in Published Japanese Translation No. 2001-510577 of PCT International Publication (corresponding PCT International Publication No. WO 1999/28790). In this case, it is not necessary to provide the focus leveling detection system so as to be able to measure the position information of the substrate in the Z-axis direction during the exposure operation, and position control of the substrate in relation to the Z axis, the θX and the θY directions can be performed using the measurement results of the laser interferometer, at least during the exposure operation.

Next, the method of exposing the substrate P using the exposure apparatus EX in the state of being selected to the first mode shall be described.

After the first mask M1 is loaded on the first mask stage 1 and the substrate P is loaded on the substrate stage 4, the control unit 5 executes predetermined processing such as adjustment of the positional relationship of the first pattern PA1 of the first mask M1 and the shot field SH on the substrate P. Once the predetermined processing is completed, the control unit 5 starts exposure of the shot field SH of the substrate P.

The exposure light L1 that is emitted from the first illumination system IL1 illuminates the first pattern PA1 of the first mask M1 on the first mask stage 1. The exposure light L1 from the first pattern PA1 of the first mask M1 is incident on the optical element 20 via the first optical system 41. As mentioned above, in the first embodiment, the exposure light L1 from the first pattern PA1 is exposure light in the circumferential polarization state that includes a P-polarization component and an S-polarization component. The optical element 20 separates the exposure light L1 into the first exposure light L11 having a P-polarization component as its main component and the second exposure light L12 having an S-polarization component as its main component. The first exposure light L11 passes through the predetermined surface 25 of the optical element 20 to be irradiated on the first exposure field AR1 via the third optical system 43.

Meanwhile, the second exposure light L12 is reflected by the predetermined surface 25 of the optical element 20 to be made incident on the first optical unit LU1. The first optical unit LU1 converts the polarization state of the second exposure light L12 in the S-polarization state to the P-polarization state and makes it incident on the predetermined surface 25 of the optical element 20. The second exposure light L12 in the P-polarization state that is incident on the predetermined surface 25 of the optical element 20 passes through the predetermined surface 25 to be incident on the second optical unit LU2. The second optical unit LU2 converts the polarization state of the second exposure light L12 in the P-polarization state to the S-polarization state and makes it incident on the predetermined surface 25 of the optical element 20. The second exposure light L12 in the S-polarization state that is incident on the predetermined surface 25 of the optical element 20 from the second optical unit LU2 is reflected by the predetermined surface 25 to be irradiated on the first exposure field AR1 via the third optical system 43.

In this way, the first exposure light L11 having a P-polarization component as its main component and the second exposure light L12 having an S-polarization component as its main component that are emitted from the fourth surface 24 of the optical element 20 are irradiated onto the first exposure field AR1. The shot field SH on the substrate P is exposed by the first exposure light L11 having a P-polarization component as its main component and the second exposure light L12 having an S-polarization component as its main component that are emitted from the optical element 20.

As mentioned above, the first optical system PL forms the image of the first pattern PA1 on the first exposure field AR1 based on the first and second exposure lights L11 and L12 irradiated on the first exposure field AR1 via the first pattern PA1 and the optical element 20. The exposure apparatus EX exposes the shot field SH on the substrate P with the image of the first pattern PA1 that is formed on the first exposure field AR1.

Furthermore, in the present embodiment, the exposure apparatus EX projects the image of the first pattern PA1 of the first mask M1 onto the substrate P while the first mask M1 and the substrate P are simultaneously moved in a predetermined scanning direction. That is, the exposure apparatus EX of the present embodiment is a scanning type exposure apparatus (a so-called scanning stepper). In the present embodiment, the scanning direction (simultaneous movement direction) of the substrate P is the Y-axis direction, and the scanning direction (simultaneous movement direction) of the first mask M1 is the Y-axis direction. The exposure apparatus EX moves the shot field SH on the substrate P in the Y-axis direction with respect to the first exposure field AR1 and, in synchronous with the movement in the Y-axis direction of the first substrate P, irradiates the first and second exposure lights L11 and L12 from the optical element 20 of the first optical system PL onto the first exposure field AR1 while moving the first mask M1 in the Y-axis direction. Thereby, it exposes (singly exposes) the shot field SH on the substrate P with the image of the first pattern PA1 that is formed on the first exposure field AR1.

The exposure apparatus EX of the state selected to the first mode was described above. As mentioned above, the first mode is a mode that singly exposes the shot field SH on the substrate P with an image of the first pattern PA1 that is formed on the first exposure field AR1 by irradiating the exposure lights L11 and L12 on the first exposure field AR1 via the first pattern PA1 and the optical element 20. In the first mode, the second optical system HL is arranged at a predetermined position with respect to the first optical system PL. The second optical system HL processes the second exposure light L12 among the separated first exposure light L11 and second exposure light L12 so that the first exposure light L11 and second exposure light L12, which are made incident on the optical element 20 from the first pattern PA1 and separated by the optical element 20, are respectively irradiated onto the substrate P.

As mentioned above, the second optical system is detachable from the first optical system PL. The exposure apparatus EX of the present embodiment can select a second mode in which, in the state of the second optical system HL not being attached, the optical element 20 of the first optical system PL combines the exposure light L1 from the first pattern PA1 that passes through the predetermined surface 25 and an exposure light L2 from a second pattern PA2 that is reflected by the predetermined surface 20 and emits the combined exposure lights L1 and L2 to multiply expose a shot field SH on the substrate P with the combined exposure lights L1 and L2.

The exposure apparatus EX of the state selected to the second mode is described below with reference to FIG. 6 to FIG. 14.

The exposure apparatus EX in the state selected to the second mode multiply exposes the shot field SH on the substrate P with an image of the first pattern PA1 that is formed on the first exposure field AR1 by irradiating the exposure light L1 on the first exposure field AR1 via the first pattern PA1 and the optical element 20 and with an image of the second pattern PA2 that is formed on the second exposure field AR2 by irradiating the exposure light L2 on the second exposure field AR2 via the second pattern PA2 and the optical element 20. In the present embodiment, the first pattern PA1 and the second pattern PA2 are different patterns.

The exposure apparatus EX in the state selected to the second mode multiply exposes the shot field SH on the substrate P with the image of the first pattern PA1 and the image of the second pattern PA2 by making the exposure light L1 from the first pattern PA1 and the exposure light L2 from the second pattern PA2 incident on the optical element 20. The optical element 20 of the first optical system PL is arranged at a position at which the exposure lights L1 and L2 can be incident, and the first optical system PL irradiates the exposure lights L1 and L2 onto the substrate P from the optical element 20.

In the case that the second mode is selected, the second optical system HL is removed from the first optical system PL. Then, as shown in FIG. 6, a second mask stage 2 that is capable of holding and moving a second mask M2 having a second pattern PA2 and a second illumination system IL2 that illuminates the second pattern PA2 of the second mask M2 with the exposure light L2 are provided at predetermined positions with respect to the first optical system PL.

The second illumination system IL2 has substantially the same construction as the first illumination system IL1. The second illumination system IL2 illuminates a second illumination field IA2 on a second mask M2 held in the second mask stage 2, with second exposure light L2 of a uniform luminance distribution. Furthermore, in the second mode, a second light source device 12 corresponding to the second illumination system IL2 is provided. For the second exposure light L2 emitted from the second illumination system IL2, for example emission lines (g-ray, h-ray, i-ray), emitted for example from a mercury lamp, deep ultraviolet beams (DUV light beams) such as the KrF excimer laser beam (wavelength: 248nm), and vacuum ultraviolet light beams (VUV light beams) such as the ArF excimer laser beam (wavelength: 193nm) and the F₂ laser beam (wavelength: 157nm), can be used. In this embodiment, an ArF excimer laser apparatus is used as the second light source device 12, and the ArF excimer laser beam is used for the exposure light L2 emitted from the second illumination system IL2, similarly to the exposure light L1 emitted from the first illumination system IL1.

The second mask stage 2 is movable by driving of a second mask stage drive device 2D which includes an actuator such as a linear motor, in the Z axis, the X axis, and the θY directions in a condition with the second mask M2 held. The second mask stage 2 holds the second mask M2 so that a second pattern forming surface on which with the second pattern PA2 of the second mask M2 is formed is substantially parallel with the XZ plane. Position information of the second mask stage 2 (and in turn the second mask M2) is measured by a laser interferometer 32 of the measurement system 3. The laser interferometer 32 measures the position information of the second mask stage 2 using a reflecting surface 32K of a moving mirror provided on the second mask stage 2. The control unit 5 drives the second mask stage drive device 2D based on the measurement result of the laser interferometer 32, to perform position control of the second mask M2 which is held on the second mask stage 2.

In the second mode, an aperture stop 18 that has a predetermined aperture is disposed near the light-emitting face of the optical integrator 16 of the first illumination system IL1 (immediately after the secondary light source 17). An aperture stop 18' that has a predetermined aperture is also disposed near the light-emitting face of the optical integrator 16 of the second illumination system IL2 (immediately after the secondary light source 17).

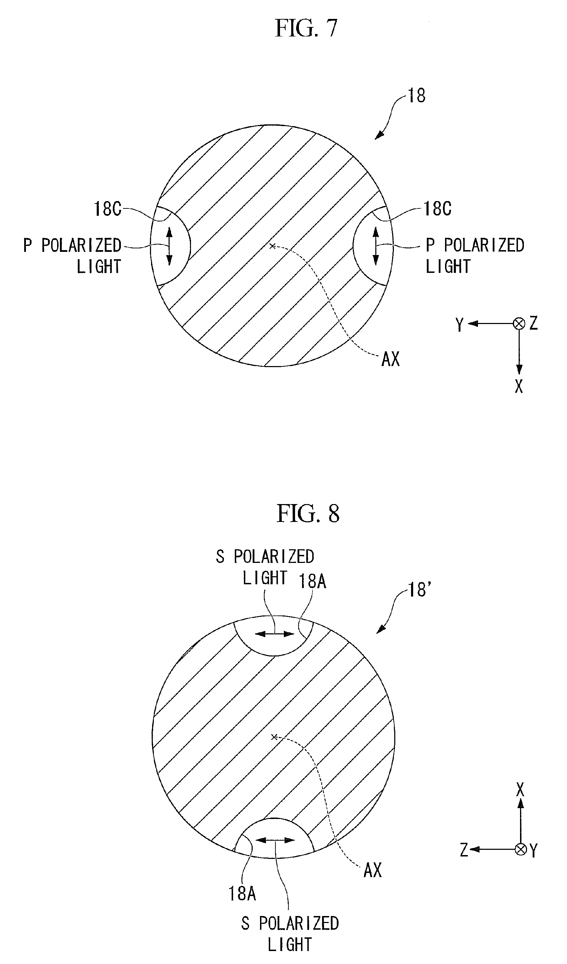

FIG. 7 is a diagram showing an example of the aperture stop 18 that is disposed in the first illumination system IL1. In FIG. 7, the aperture stop 18 has apertures 18C, 18C that can pass the exposure light L1. The apertures 18C, 18C of the aperture stop 18 are formed so as to pass the exposure light L1 that is emitted from the first circular region 17C that is formed by the exposure light L1 subjected to the rotatory polarization action of the first fundamental element 15C in the secondary light source 17 of the first illumination system IL1. The apertures 18C, 18C are provided at opposing positions sandwiching the optical axis AX of the first illumination system IL1. In the present embodiment, the apertures 18C, 18C are respectively provided on the +Y side and the -Y side with respect to the optical axis AX in FIG. 7.

The aperture stop 18 passes via the apertures 18C and 18C the exposure light L1 in a linear polarization state in which a direction parallel to the X axis serves as the polarization direction. In the present embodiment, the apertures 18C and 18C pass the exposure light L1 of the P-polarization state, which is linearly polarized light. Accordingly, the exposure light L1 that passes through the apertures 18C and 18C mainly includes a P-polarization component, and so the first mask M1 on the first mask stage 1 is illuminated by the exposure light L1 in which a P-polarization component serves as the main component.

FIG. 8 is a diagram showing an example of the aperture stop 18' that is disposed in the second illumination system IL2. In FIG. 8, the aperture stop 18' has apertures 18A and 18A that can pass the exposure light L2. The apertures 18A, 18A are provided at opposing positions sandwiching the optical axis AX of the second illumination system IL2. In the present embodiment, the apertures 18A and 18A are respectively provided on the +X side and the -X side with respect to the optical axis AX in FIG. 8.

The aperture stop 18' passes via the apertures 18A and 18A the exposure light L2 in a linear polarization state in which a direction parallel to the Z axis serves as the polarization direction. In the present embodiment, the apertures 18A and 18A pass the exposure light L2 of the S-polarization state, which is linearly polarized light. Accordingly, the exposure light L2 that passes through the apertures 18A and 18A mainly includes an S-polarization component, and so the second mask M2 on the second mask stage 2 is illuminated by the exposure light L2 in which an S-polarization component serves as its main component.

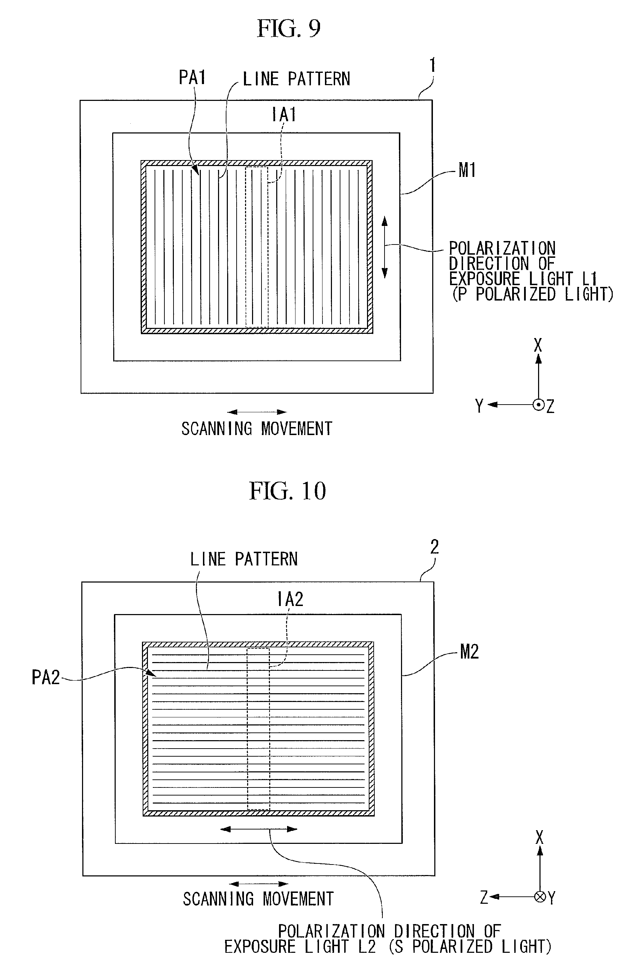

FIG. 9 is a plan view showing the first mask M1 that is held in the first mask stage 1, and FIG. 10 is a plan view showing the second mask M2 that is held in the second mask stage 2. As shown in FIG. 9 and FIG. 10, the first mask stage 1 holds the first mask M1 so that a first pattern forming surface on which the first pattern PA1 of the first mask M1 is formed is substantially parallel with the XY plane, and the second mask stage 2 holds the second mask M2 so that a second pattern forming surface on which the second pattern PA2 of the second mask M2 is formed is substantially parallel with the XZ plane. Furthermore, the first illumination field IA1 due to the first exposure light L1 on the first mask M1 is set in a rectangular shape (slit shape) with the X-axis direction as the longitudinal direction. The second illumination field IA2 due to the second exposure light L2 on the second mask M2 is also set in a rectangular shape (slit shape) with the X-axis direction as the longitudinal direction.

As shown in FIG. 9 and FIG. 10, in the second mode, the first pattern PA1 of the first mask M1 has as a main component a plurality of line-and-space patterns in which the X-axis direction serves as the longitudinal direction, and the second pattern PA2 of the second mask M2 has as a main component a plurality of line-and-space patterns in which the Z-axis direction serves as the longitudinal direction. That is, the first pattern PA1 contains many of a pattern that periodically arranges in the Y-axis direction a line pattern with the X-axis direction as the longitudinal direction, and the second pattern PA2 contains many of a pattern that periodically arranges in the X-axis direction a line pattern with the Z-axis direction as the longitudinal direction.

As mentioned above, the exposure light L1 that is irradiated on the first mask M1 has linear polarized light (P polarized light) of a predetermined direction as a main component. In the present embodiment, the polarization direction of the exposure light L1 on the first mask M1 is set to become substantially parallel with the X axis. Furthermore, the exposure light L2 that is irradiated on the second mask M2 has linear polarized light (S polarized light) of a predetermined direction as a main component. In the present embodiment, the polarization direction of the exposure light L2 on the second mask M2 is set to become substantially parallel with the Z axis.

That is, in the second mode, the longitudinal direction of the line pattern in the line-and-space pattern included in the first pattern PA1 and the polarization direction of the exposure light L1 that has P polarized light as its main component are substantially parallel. The longitudinal direction of the line pattern in the line-and-space pattern included in the second pattern PA2 and the polarization direction of the exposure light L2 that has S polarized light as its main component are substantially parallel.

In this way, in the second mode, the first illumination system IL1 performs linear polarization illumination aligned with the longitudinal direction of the line pattern in the line-and-space pattern of the first mask M1, and the second illumination system IL2 performs linear polarization illumination aligned with the longitudinal direction of the line pattern in the line-and-space pattern of the second mask M2. Much diffracted light of the P-polarization component, i.e., of the polarization direction component along the longitudinal direction of the line pattern of the first pattern PA1, is emitted from the first pattern PA1 of the first mask M1. Much diffracted light of the S-polarization component, i.e., of the polarization direction component along the longitudinal direction of the line pattern of the second pattern PA2, is emitted from the second pattern PA2 of the second mask M2.

Furthermore, the exposure light L1 that has respectively passed through the apertures 18C and 18C of the aperture stop 18 that are provided at mutually opposing positions with respect to the optical axis AX of the first illumination system IL1 is irradiated onto the first mask M1. The first pattern PA1 of the first mask M1 thus is subjected to dipole illumination by the exposure light L1 in the P-polarization state. Similarly, the exposure light L2 that has respectively passed through the apertures 18A and 18A of the aperture stop 18' that are provided at mutually opposing positions with respect to the optical axis AX of the second illumination system IL2 is irradiated onto the second mask M2. The second pattern PA2 of the second mask M2 thus is subjected to dipole illumination by the exposure light L2 in the S-polarization state.

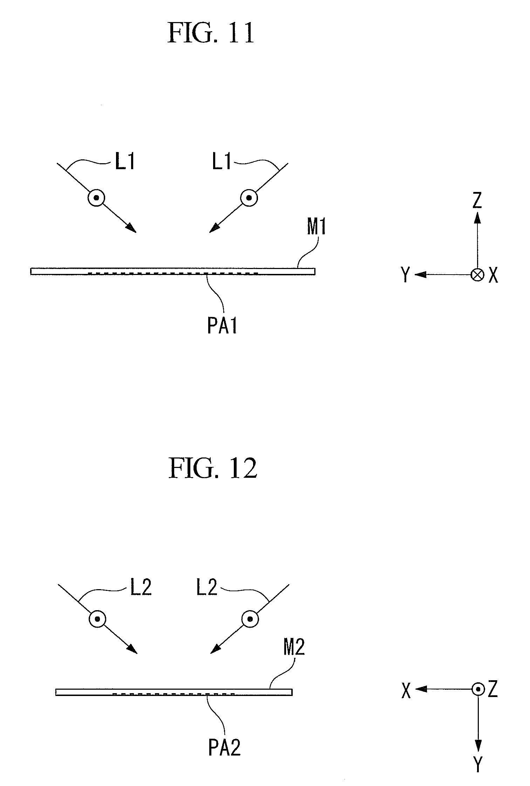

That is, in the present embodiment, as shown in the schematic diagram of FIG. 11, the first illumination system IL1 performs oblique incident illumination (dipole illumination) aligned with the longitudinal direction of the line pattern in the line-and-space pattern of the first mask M1 using the two light beams (exposure light L1) in the linear polarization state (P-polarization state). As shown in the schematic diagram of FIG. 12, the first illumination system IL1 performs oblique incident illumination (dipole illumination) aligned with the longitudinal direction of the line pattern in the line-and-space pattern of the second mask M2 using two light beams (exposure light L2) in the linear polarization state (S-polarization state). In the first pattern PA1 of the first mask M1 as shown in FIG. 11, the exposure light L1 in which the direction along the longitudinal direction of the line pattern (X-axis direction) serves as its polarization direction is incident from two directions inclined in the θX direction with respect to the surface of the first mask M1. Furthermore, in the second pattern PA2 of the second mask M2 as shown in FIG. 12, the exposure light L2 in which the direction along the longitudinal direction of the line pattern (Z-axis direction) serves as its polarization direction is incident from two directions inclined in the θZ direction with respect to the surface of the second mask M2.

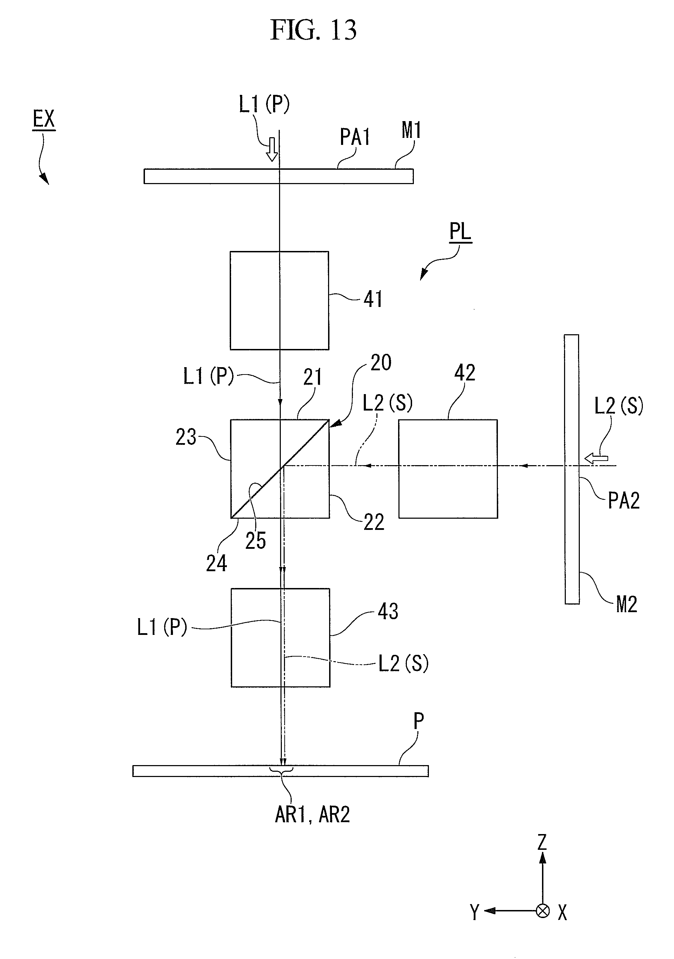

FIG. 13 is a schematic diagram showing the exposure apparatus EX in the state selected to the second mode. In the second mode, the first optical system PL projects an image of the first pattern PA1 of the first mask M1 which is illuminated by the exposure light L1 and an image of the second pattern PA2 of the second mask M2 which is illuminated by the exposure light L2 onto the substrate P at a predetermined projection magnification.

The optical element 20 of the first optical system PL is arranged at a position that the exposure light L1 from the first pattern PA1 and the exposure light L2 from the second pattern PA2 can respectively irradiate. The optical element 20 is capable of separating the exposure lights L1 and L2 that are incident and is capable of combining the exposure lights L1 and L2 that are incident.

Furthermore, in the second mode, the first optical system PL is capable of setting the first exposure field AR1 and the second exposure field AR2 in a predetermined positional relationship adjacent to the light emission side of the first optical system PL, that is, the image surface side of the first optical system PL, and irradiating the exposure light L1 and the exposure light L2 from the optical element 20 towards the first exposure field AR1 and the second exposure field AR2. Furthermore, the projection optical system PL is capable of forming an image of the first pattern PA1 on the first exposure field AR1, and is capable of forming an image of the second pattern PA2 on the second exposure field AR2.

In the second mode, the exposure apparatus EX makes the exposure light L1 from the first pattern PA1 and the exposure light L2 from the second pattern PA2 incident on the optical element 20, combines the exposure light L1 from the first pattern PA1 and the exposure light L2 from the second pattern PA2 with the optical element 20, and irradiates them on the first exposure field AR1 and the second exposure field AR2, respectively.

As mentioned above, the first optical system PL has the first optical system 41 that guides the exposure light L1 from the first pattern PA1 to the optical element 20 and the second optical system 42 that is disposed at a predetermined position with respect to the optical element 20. The second mask stage 2 is arranged adjacent to the -Y side of the second optical system 42, and the second optical system 42 guides the exposure light L2 from the second pattern PA2 to the optical element 20. Furthermore, the third optical system 43 guides the first and second exposure lights L11 and L12 from the optical element 20 to the first exposure field AR1 and the second exposure field AR2, respectively.

The exposure light L1 from the first pattern PA1 of the first mask M1 is incident on the first surface 21 of the optical element 20 via the first optical system 41, and the exposure light L2 from the second pattern PA2 of the second mask M2 is incident on the second surface 22 of the optical element 20 via the second optical system 42. As mentioned above, the exposure light L1 that is irradiated on the first pattern PA1 is exposure light that has a P-polarization component as its main component, and the exposure light L2 that is irradiated on the second pattern PA2 is exposure light that has an S-polarization component as its main component. Accordingly, in addition to the exposure light L1 that has a P-polarization component as its main component from the first pattern PA1 being incident on the optical element 20, the exposure light L2 that has an S-polarization component as its main component from the second pattern PA2 is incident on the optical element 20. In this way, in the second mode, the exposure apparatus EX makes the exposure light L1 having a P-polarization component as its main component from the first pattern PA1 incident on the optical element 20 and makes the exposure light L2 having an S-polarization component as its main component from the second pattern PA2 incident on the optical element 20.

As mentioned above, the optical element 20 includes a polarization separation optical element (polarization beam splitter), and the predetermined surface (polarization separation surface) 25 of the optical element 20 passes the exposure light of the P-polarization state and reflects exposure light of the S-polarization state. Accordingly, the exposure light L1 having a P-polarization component as its main component from the first pattern PA1 passes through the predetermined surface 25 of the optical element 20 to be guided to the first exposure field AR1 via the third optical system 43. Furthermore, the exposure light L2 having an S-polarization component as its main component from the second pattern PA2 is reflected by the predetermined surface 25 of the optical element 20 to be guided to the second exposure field AR2 via the third optical system 43.

Next, the method of exposing the substrate P using the exposure apparatus EX in the state of being selected to the second mode shall be described.

The first mask M1 is loaded on the first mask stage 1, and the second mask M2 is loaded on the second mask stage 2. After the substrate P is loaded onto the substrate stage 4, the control unit 5 executes predetermined processing such as adjustment of the positional relationship of the first pattern PA1 of the first mask M1, and the second pattern PA2 of the second mask M2, and the shot field SH on the substrate P. Once the predetermined processing is completed, the control unit 5 starts exposure of the shot field SH of the substrate P.

The exposure light L1 that is emitted from the first illumination system IL1 illuminates the first pattern PA1 of the first mask M1 on the first mask stage 1. The exposure light L1 from the first pattern PA1 of the first mask M1 is incident on the optical element 20 via the first optical system 41. The exposure light L1 from the first pattern PA1 is exposure light having a P-polarization component as its main component. The predetermined surface 25 of the optical element 20 passes the exposure light L1 having a P-polarization component as its main component. The exposure light L1 that has passed through the predetermined surface 25 of the optical element 20 is emitted from the fourth surface 24 and irradiated on the first exposure field AR1 via the third optical system 43.

Furthermore, the exposure light L2 that is emitted from the second illumination system IL2 illuminates the second pattern PA2 of the second mask M2 on the second mask stage 2. The exposure light L2 from the second pattern PA2 of the second mask M2 is incident on the optical element 20 via the second optical system 42. The exposure light L2 from the second pattern PA2 is exposure light having an S-polarization component as its main component. The predetermined surface 25 of the optical element 20 reflects the exposure light L2 having an S-polarization component as its main component. The exposure light L2 that is reflected by the predetermined surface 25 of the optical element 20 is emitted from the fourth surface 24 and irradiated on the second exposure field AR2 via the third optical system 43.

In this way, the exposure light L1 having a P-polarization component as its main component that is emitted from the fourth surface 24 of the optical element 20 is irradiated onto the first exposure field AR1, and the exposure light L2 having an S-polarization component as its main component that is emitted from the fourth surface 24 of the optical element 20 is irradiated onto the second exposure field AR2. The shot field SH on the substrate P is multiply exposed by the exposure light L1 having a P-polarization component as its main component and the exposure light L2 having an S-polarization component that are emitted from the optical element 20.

The first optical system PL forms the image of the first pattern PA1 on the first exposure field AR1 based on the exposure light L1 irradiated on the first exposure field AR1 via the first pattern PA1 and the optical element 20, and forms the image of the second pattern PA2 on the second exposure field AR2 based on the exposure light L2 irradiated on the second exposure field AR2 via the second pattern PA2 and the optical element 20. The exposure apparatus EX multiply exposes the shot field SH on the substrate P with the image of the first pattern PA1 that is formed on the first exposure field AR1 and the image of the second pattern PA2 that is formed on the second exposure field AR2.

The exposure apparatus EX in the state selected to the second mode projects the image of the first pattern PA1 of the first mask M1 and the image of the second pattern PA2 of the second mask M2 onto the substrate P while the first mask M1, the second mask M2, and the substrate P are simultaneously moved in their predetermined scanning directions. In the present embodiment, the scanning direction (the simultaneous movement direction) of the substrate P is the Y axis direction. The exposure apparatus EX respectively irradiates the exposure light L1 and the exposure light L2 onto the first exposure field AR1 and the second exposure field AR2 via the first optical system PL while moving the shot field SH on the substrate P in the Y-axis direction with respect to the first exposure field AR1 and the second exposure field AR2. Thereby, the exposure apparatus EX multiply exposes the shot field SH on the substrate P with the image of the first pattern PA1 formed on the first exposure field AR1 and the image of the second pattern PA2 formed on the second exposure field AR2. Furthermore, the exposure apparatus EX, in synchronous with the movement in the Y axis direction of the substrate P, multiply exposes the shot field SH on the substrate P while moving the first pattern PA1 of the first mask M1 and the second pattern PA2 of the second mask M2 in their predetermined scanning directions. In the present embodiment, the scanning direction (synchronous movement direction) of the first mask M1 is the Y-axis direction, and the scanning direction (synchronous movement direction) of the second mask M2 is the Z-axis direction.

The first mask stage 1 is capable of moving the first mask M1 having the first pattern PA1 in the Y-axis direction with respect to the exposure light L1. Furthermore, the second mask stage 2 is capable of moving the second mask M2 having the second pattern PA2 in the Z-axis direction with respect to the exposure light L2. Furthermore, the substrate stage 4 is capable of moving the substrate P within a predetermined field including the first exposure field AR1 and the second exposure field AR2 that are irradiated by the exposure light L1 and the exposure light L2.

The control unit 5, when exposing the shot field SH on the substrate P, controls the first mask stage 1 so that a first pattern forming field of the first mask M1 in which is formed at least the first pattern PA1 passes through the first illumination field IA1 due to the exposure light L1, to move the first mask M1 in the Y-axis direction. Furthermore, the control unit 5, when exposing the shot field SH on the substrate P, controls the second mask stage 2 so that a second pattern forming field of the second mask M2 in which is formed at least the second pattern PA2 passes through the second illumination field IA2 due to the exposure light L2, to move the second mask M2 in the Z-axis direction. Furthermore, the control unit 5, when exposing the shot field SH on the substrate P, controls the substrate stage 4 so that the shot field SH on the substrate P passes through the first exposure field AR1 and the second exposure field AR2, to move the substrate P in the Y-axis direction.

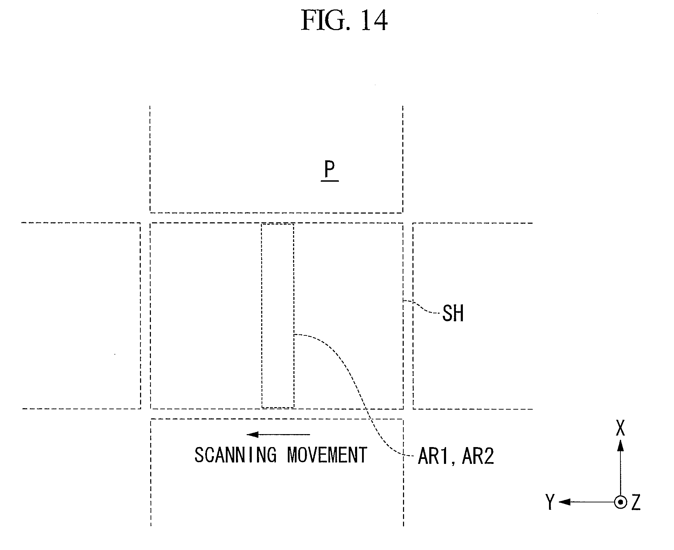

As shown in FIG. 14, in the present embodiment, each of the first exposure field AR1 and the second exposure field AR2 are set in a rectangular shape (slit shape) with the X-axis direction as the longitudinal direction. Furthermore, the first exposure field AR1 and the second exposure field AR2 overlap.

Under the control of the control unit 5, while monitoring the position information of the first mask stage 1, the second mask stage 2, and the substrate stage 4 with the measurement system 3, movement of the substrate P in the Y-axis direction with respect to the first exposure field AR1 and the second exposure field AR2, movement of the first mask M1 in the Y-axis direction with respect to the first illumination field IA1, and movement of the second mask M2 in the Y-axis direction with respect to the second illumination field IA2 are synchronously performed. The exposure light L1 from the first pattern PA1 and the exposure light L2 from the second pattern PA2 are irradiated on the first exposure field AR1 and the second exposure field AR2, and the shot field SH on the substrate P is multiply exposed.

The exposure apparatus EX in the state selected to the second mode can in one round of the scanning operation multiply expose the shot field SH on the substrate P with the image of the first pattern PA1 and the image of the second pattern PA2. The photosensitive material layer of the shot field SH on the substrate P is multiply exposed by the exposure light L1 irradiated onto the first exposure field AR1 and the exposure light L2 irradiated onto the second exposure field AR2 without going through development steps and the like.

As described above, the exposure apparatus EX of the present embodiment can select the first mode that singly exposes (normally exposes) the shot field SH on the substrate P with an image of the first pattern PA1 that is formed on the first exposure field AR1 by irradiating the exposure lights L11, L12 on the first exposure field AR1 via the first pattern PA1 and the optical element 20, and the second mode that multiply exposes (double exposes) the shot field SH on the substrate P with an image of the first pattern PA1 that is formed on the first exposure field AR1 by irradiating the exposure light L1 on the first exposure field AR1 via the first pattern PA1 and the optical element 20 and an image of the second pattern PA2 that is formed on the second exposure field AR2 by irradiating the exposure light L2 on the second exposure field AR2 via the second pattern PA2 and the optical element 20.

In the second mode, the first illumination system IL1 can perform linear polarization illumination (P-polarization illumination) that suits the first pattern (line pattern) PA1 of the first mask M1. The second illumination system IL2 can perform linear polarization illumination (S-polarization illumination) that suits the second pattern (line pattern) PA2 of the second mask M2. Thereby, the first and second patterns PA1 and PA2 are favorably formed on the substrate P. That is, since the exposure light having a polarization direction that is substantially parallel to the longitudinal direction of the line pattern contributes to improving the contrast of the image of the line pattern, it is possible to improve the optical performance (focal depth, etc.) of the first optical system PL and obtain images of the first and second patterns PA1 and PA2 with high contrast on the substrate P. When the numerical aperture NA of the first optical system PL is as large as 0.9 or greater for example, the image formation characteristics can deteriorate due to the polarization effect in random polarized light. In the present embodiment, it is possible to obtain a favorable image of a pattern since polarized illumination is used. By making each of the exposure light L1 from the first pattern PA1 that has a P-polarization component as its main component and the exposure light L2 from the second pattern PA2 that has an S-polarization component as its main component incident on the optical element (polarization separation optical element) 20, it is possible to combine the exposure light L1 and the exposure light L2 by the optical element 20. As a result, the shot field SH on the substrate P can be multiply exposed with good efficiency by the two exposure lights L1 and L2 that are emitted from the optical element 20.

Furthermore, in the first mode, by arranging the second optical system HL at a predetermined position with respect to the first optical system PL that has the optical element 20, even when illuminating the first pattern PA1 of the first mask M1 with the exposure light L1 of the circumferential polarization state including at least a P-polarization component and an S-polarization component, it is possible to make the exposure light L1 reach the substrate P via the optical element 20. For example, in the case of the first pattern PA1 being a pattern that includes various shapes such as a logic pattern (a pattern that mixes a line pattern having a predetermined direction as a longitudinal direction and a line pattern having a direction intersecting that predetermined direction as a longitudinal direction), there are cases when it is desirable to illuminate with the exposure light L1 that includes at least a P-polarization component and an S-polarization component, such as for example in a circumferential polarization state. In the case of the first optical system PL having the optical element (polarization separation optical element) 20, when illuminating the first pattern PA1 with at least a P-polarization component and an S-polarization component there is a possibility of, for example, the exposure light of the S-polarization state among the exposure light L1 that is incident on the optical element 20 not being able to reach the substrate P. In the present embodiment, when singly exposing the shot field SH on the substrate P with one pattern (first pattern) PA1, by disposing the second optical system HL at a predetermined position with respect to the first optical system PL and making the exposure light L1 that includes at least a P-polarization component and an S-polarization component from the first pattern PA1 incident on the optical element (polarization separation optical element) 20, most of the exposure light L1 from the first pattern PA1 can be made to reach the substrate P. Accordingly, even when the first pattern PA1 is a pattern that includes various shapes, that pattern can be favorably formed on the substrate P.

In this way, in the present embodiment, when the second mode is selected, the shot field SH on the substrate P can be multiply exposed (double exposed) with good efficiency by using the optical element (polarization separation optical element) 20 that is arranged in the light path of the exposure light. Furthermore, when the first mode is selected, even when the polarization separation optical element is arranged in the light path of the exposure light, it is possible to prevent the illumination conditions (polarization direction of the exposure light) becoming constrained when illuminating the pattern with the exposure light. It is therefore possible to illuminate the pattern with the most suitable illumination conditions for the pattern and make the exposure light that illuminates the pattern reach the substrate P. Accordingly, it is possible to favorably cater to a diversification of patterns and thus favorably form various patterns on the substrate P.

In the first mode of the present embodiment, the first exposure light L11 that passes through the predetermined surface 25 of the optical element 20 is irradiated on the substrate P not via the second optical system HL, while the second exposure light L 12 that is reflected by the predetermined surface 25 is made incident on the second optical system HL to be irradiated on the substrate P via the second optical system HL. However, the exposure light that is reflected by the predetermined surface 25 of the optical element 20 can be irradiated on the substrate P not via the second optical system HL, and the exposure light that has passed through the predetermined surface 25 can be made incident on the second optical system HL to be irradiated on the substrate P via the second optical system HL. Furthermore, in the present embodiment, the first optical unit LU1 makes the incident exposure light of the S-polarization state incident on the optical element 20 after conversion to exposure light of the P-polarization state. However, exposure light of the P-polarization state can be made incident on the first optical unit LU1, and after converting the exposure light of the P-polarization state that is incident to exposure light of the S-polarization state by the first optical unit LU1, the exposure light can be made incident on the optical element 20. Furthermore, the second optical unit LU2 makes the incident exposure light of the P-polarization state incident on the optical element 20 after conversion to exposure light of the S-polarization state. However, the exposure light of the S-polarization state can be made incident on the second optical unit LU2, and after converting the exposure light of the S-polarization state that is incident to exposure light of the P-polarization state by the second optical unit LU2, the exposure light can be made incident on the optical element 20.

In the first mode, when a difference in the quantity of light of a first exposure light L11 and a second exposure light L12 reaching for example the substrate P occurs, it is possible to arrange a correcting optical element so as to correct that difference in the quantity of light. Such a difference in the quantity of light is caused by a difference between the first light path along which proceeds the first exposure light L11 which passes through the predetermined surface 25 of the optical element 20 to be irradiated on the substrate P not via the second optical system HL, and the second light path along which proceeds the second exposure light L12 which is reflected by the predetermined surface 25 of the optical element 20 to be irradiated on the substrate P via the second optical system HL, among the exposure light L1 from the first pattern PA1.

In the present embodiment, the case where the optical element 20 is a polarization beam splitter was described as an example. However, the optical element 20 can for example also be a half mirror (spectral mirror). In the case of using a half mirror as the optical element 20, the polarization conversion element of the second optical system HL can be omitted.

### <Second Embodiment>

A second embodiment shall henceforth be described. In the following description, components the same as or similar to the abovementioned embodiment are denoted by the same reference symbols, and their description is simplified or omitted.

The characteristic part of this embodiment is the point that in the case of the first mode being selected, an optical element 20' with no refracting power is arranged at a position at which a plurality of exposure lights can be incident, and in the case of the second mode being selected, an optical element 20 that is capable of separating a plurality of incident exposure lights and combining a plurality of incident exposure lights is arranged at a position at which a plurality of exposure lights can be incident, and by making the exposure light L1 from the first pattern PA1 and the exposure light L2 from the second pattern PA2 incident on the optical element 20 and combining the exposure light L1 from the first pattern PA1 and the exposure light L2 from the second pattern PA2 with the optical element 20, the first exposure field AR1 and the second exposure field AR2 are respectively irradiated.

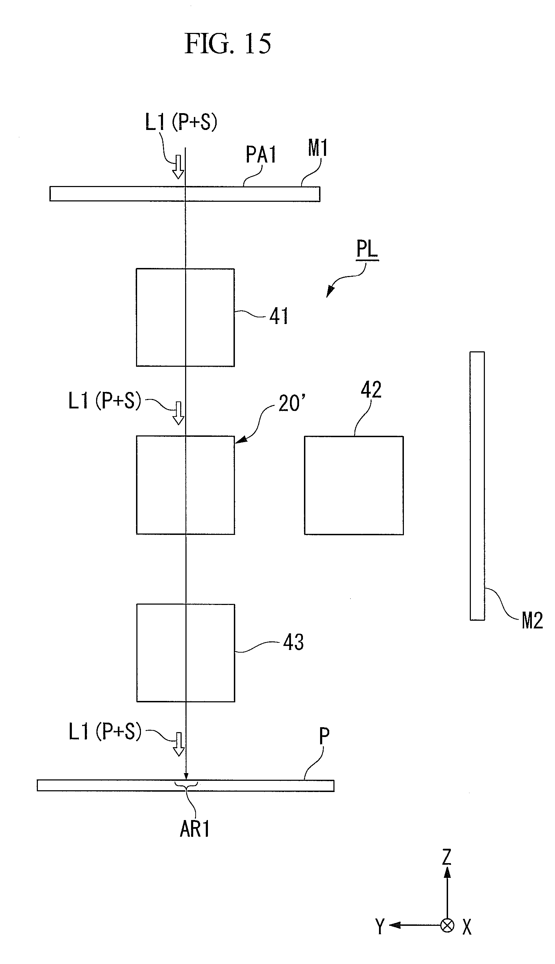

FIG. 15 is a schematic diagram showing the exposure apparatus EX according to the second embodiment in the state of the first mode being selected. As shown in FIG. 15, in the case of the first mode being selected, the optical element 20' with no refracting power is arranged at a position at which the exposure lights L1 and L2 can be incident. The optical element 20' includes, for example, a plane parallel plate formed from quartz. By arranging the optical element 20' with no refracting power, the exposure light L1 from the first pattern PA1 that includes at least a P-polarization component and an S-polarization component, by passing through the optical element 20', can reach the substrate P.

Furthermore, in the exposure apparatus EX according to the second embodiment, in the case of the second mode being selected, the optical element 20' with no refracting power is replaced with the optical element 20 described in the first embodiment. Thereby, similarly to the first embodiment mentioned above, it is possible to multiply expose the shot field SH on the substrate P with the exposure light L1 from the first pattern PA1 that has a P-polarization component as its main component and the exposure light L2 from the second pattern PA2 that has an S-polarization component as its main component. In order to facilitate the replacement, a liquid with a refractive index nearly equal to the optical elements 20 and 20' can be added in front or in back of the optical element 20 or the optical element 20'.

In the second embodiment, when the first mode is selected, the optical element 20 that is arranged at a position at which a plurality of exposure lights can be incident can simply be removed. That is, when the first mode is selected, it is acceptable to place nothing at the position at which the optical element 20 was arranged in the second mode. In this case, a correcting mechanism for changes in the light path length can be provided in the first optical system 41 or the third optical system 43.

In the aforementioned first and second embodiments, the first optical system PL is not limited to that described above, and for example either an equal magnification system or a magnification system can be used. Furthermore, the first optical system PL can be a refractive system which does not include a reflecting optical element, a reflecting system which does not include a refractive optical element, or a reflection/refraction system which includes both a reflecting optical element and a refractive optical element.

Furthermore, in the abovementioned respective embodiments, when the second mode is selected, at least one of the size and the shape of the first exposure field AR1 and the second exposure field AR2 can be mutually different. For example, the width in the X axis direction and/or the width in the Y axis direction of the first exposure field AR1 and the second exposure field AR2 can be different.

Furthermore, in the abovementioned respective embodiments, irradiation of the exposure light L1 and the exposure light L2 on the first exposure field AR1 and the second exposure field AR2, respectively, is continued while the shot field SH is passing through the first exposure field AR1 and the second exposure field AR2. However, the exposure light can be irradiated for only a portion of the period of time in which the shot field SH passes through at least one of the first exposure field AR1 and the second exposure field AR2. That is to say, it is acceptable to multiply expose only a portion within the shot field SH.

In the abovementioned respective embodiments, an immersion method such as disclosed for example in PCT International Patent Publication No. WO 1999/49504 can be applied. For example, a liquid immersion field can be formed on the substrate P so as to cover the exposure fields, and the exposure lights can be irradiated onto the substrate P via the liquid. As the liquid, water (pure water) can be used. Other than water, for example a fluorocarbon fluid such as a perfluoropolyether (PFPE) or a fluorocarbon oil, or a cedar oil or the like can be used. Moreover, as the liquid, a liquid with a refractive index that is higher than that of water with respect to the exposure light (for example a liquid with a refractive index of approximately 1.6 to 1.8) can be used. Furthermore, an optical element that forms the first and second optical systems PL and HL can be formed from a material with a refractive index that is higher than that of quartz or fluorite (for example 1.6 or more). Here, a liquid LQ with a refractive index that is higher than that of pure water (for example, 1.5 or higher) includes for example a predetermined liquid with a C-H bond and an O-H bond such as isopropanol with a refractive index of approximately 1.5 and glycerol (glycerine) with a refractive index of approximately 1.61; a predetermined liquid (organic solvent) such as hexane, heptane, decane; and Decalin (Decahydronaphthalene) with a refractive index of approximately 1.60. Alternatively, the liquid LQ can be one that is a mixture of two or more types of optional liquids among these predetermined liquids, or one that is made by adding (mixing) at least one of these liquids to/with pure water. Alternatively, as the liquid LQ, one in which an acid or a base such as H⁺, Cs⁺, and K⁺, or Cl⁻, SO₄²⁻, and PO₄²⁻ is added to (mixed with) pure water can be used, and a liquid in which fine particles of for example A1 oxide are added to (mixed with) pure water can be used. Furthermore, the liquid is preferably one for which the light absorption coefficient is small, the temperature dependency is small, and which is stable with respect to the photosensitive material (or top coat film or anti-reflection film, etc.) painted on the surface of the projection optical system and/or the substrate. It is possible to use a supercritical solution as the liquid. Furthermore, a top coat film and the like that protects the photosensitive material and substrate from the liquid can be provided on the substrate. Furthermore, a final optical element can be formed from quartz (silica) or a single crystal material of a fluoride compound such as calcium fluoride (fluorite), barium fluoride, strontium fluoride, lithium fluoride, and sodium fluoride, and can be formed from a material with a refractive index that is higher than that of quartz or fluorite (for example 1.6 or more). As materials with a refractive index that is 1.6 or more, it is possible to use sapphire and germanium dioxide, etc., disclosed in PCT International Patent Publication No. WO 2005/059617, and potassium chloride (refractive index of approximately 1.75) disclosed in PCT International Patent Publication No. WO 2005/059618.

In the case of using an immersion method, it is acceptable to fill the light path on the object surface side of the final optical element in addition to the light path of the image surface side of the final optical element with a liquid, as disclosed in PCT International Patent Publication No. WO 2004/019128 (corresponding U.S. Patent Application Publication No. 2005/0248856). Moreover, a thin film that has lyophilicity and/or a dissolution prevention mechanism can be formed on a portion of the surface of the final optical element (including at least the contact surface with the liquid) or all thereof. Note that silica has a high affinity with liquid, and a dissolution prevention mechanism is not required, but it is preferable to at least form a dissolution prevention film in the case of fluorite.

The above respective embodiments are ones which measure the position information of the mask stage and the substrate stage using an interferometer system as the measurement system 3. However, the invention is not limited to this, and for example an encoder system that detects a scale (grating) provided for example on the top surface of the substrate stage can be used. In this case, as a hybrid system which uses both the interferometer system and the encoder system, preferably the measurement results of the interferometer system are used to perform calibration on the measurement results of the encoder system. Furthermore, the interferometer system and the encoder system can be alternately used, or both can be used, to perform position control of the substrate stage.

As the substrate P in the abovementioned respective embodiments, not only a semiconductor wafer for manufacturing a semiconductor device, but also a glass substrate for a display device, a ceramic wafer for a thin film magnetic head, or a mask or an original plate of a reticle (synthetic quartz or silicon wafer) used in an exposure apparatus, or a film member etc. can be used. Furthermore, the shape of the substrate is not limited to a circle, and can be another shape such as a rectangle.

Furthermore, the exposure apparatus EX of the aforementioned embodiments can be provided with a measurement stage that is capable of moving independently of the substrate stage that holds the substrate, and on which is mounted a measurement member (for example, a reference member formed with a reference mark, and/or various types of photoelectronic sensors), as disclosed for example in Japanese Unexamined Patent Application, First Publication No. H11-135400 (corresponding PCT International Publication No. WO 1999/23692), and Japanese Unexamined Patent Application, First Publication No. 2000-164504 (corresponding U.S. Patent No. 6,897,963).

In the abovementioned respective embodiments, a mask for forming a pattern was used, but it is possible to use instead an electronic mask that generates a variable pattern (also called a variable forming mask, an active mask, or a pattern generator). As an electronic mask, it is possible to use a deformable micro-mirror device or digital micro-mirror device (DMD) that is one type of non-light emitting type image display element (also called a spatial light modulator (SLM)). A DMD has a plurality of reflecting elements (micro-mirrors) that are driven based on predetermined electronic data. This plurality of reflecting elements are arrayed in a two-dimensional matrix on the surface of the DMD and are driven individually to reflect and deflect the exposure light. The angle of each reflecting element with reflect to the reflecting surface is adjusted. The operation of the DMD can be controlled by the control unit. The control unit drives the reflecting elements of the DMD based on the electronic data (pattern information) according to the pattern to be formed on the substrate and thus patterns with the reflecting elements the exposure light that is irradiated by the illumination system. By using the DMD, compared to the case of exposing by using a mask (reticle) on which is formed a pattern, mask changing work and an operation to align the position of the mask in the mask stage are unnecessary when changing the pattern. In an exposure apparatus that employs an electronic mask, the substrate can simply move in the X-axis and Y-axis directions by a substrate stage without providing a mask stage. An exposure apparatus that uses a DMD is disclosed for example in Japanese Unexamined Patent Application, First Publication No. H08-313842, Japanese Unexamined Patent Application, First Publication No. 2004-304135, and U.S. Patent No. 6,778,257.

The present invention can also be applied to a multistage type exposure apparatus provided with a plurality of substrate stages as disclosed for example in Japanese Unexamined Patent Application, First Publication No. H10-163099, Japanese Unexamined Patent Application, First Publication No. H10-214783 (corresponding U.S. Patent No. 6,341,007, No. 6,400,441, No. 6,549, 269, and No. 6,590,634), and Published Japanese Translation No. 2000-505958 of PCT International Publication (corresponding U.S. Patent No. 5,969,441).

The types of exposure apparatuses EX are not limited to exposure apparatuses for semiconductor device manufacture that expose a semiconductor device pattern onto a substrate P, but are also widely applicable to exposure apparatuses for the manufacture of liquid crystal display devices and for the manufacture of displays, and exposure apparatuses for the manufacture of thin film magnetic heads, image pickup devices (CCDs), micro machines, MEMS, DNA chips, and reticles or masks.

As far as is permitted, the disclosures in all of the Japanese Patent Publications and U.S. Patents related to exposure apparatuses and the like cited in the above respective embodiments and modified examples, are incorporated herein by reference.

As described above, the exposure apparatus EX of the aforementioned embodiments is manufactured by assembling various subsystems, including the respective constituent elements, so that predetermined mechanical, electrical, and optical accuracies are maintained. To ensure these various accuracies, adjustments are performed before and after this assembly, including an adjustment to achieve optical accuracy for the various optical systems, an adjustment to achieve mechanical accuracy for the various mechanical systems, and an adjustment to achieve electrical accuracy for the various electrical systems. The process of assembling the exposure apparatus from the various subsystems includes, for example, the mutual mechanical connection of the various subsystems, the wiring and connection of electrical circuits, and the piping and connection of the atmospheric pressure circuit. Naturally, before the process of assembling the exposure apparatus from these various subsystems, there are also the processes of assembling each individual subsystem. When the process of assembling the exposure apparatus from the various subsystems is completed, a comprehensive adjustment is performed to ensure the various accuracies of the exposure apparatus as a whole. Furthermore, it is preferable to manufacture the exposure apparatus in a clean room wherein, for example, the temperature and the cleanliness level are controlled.

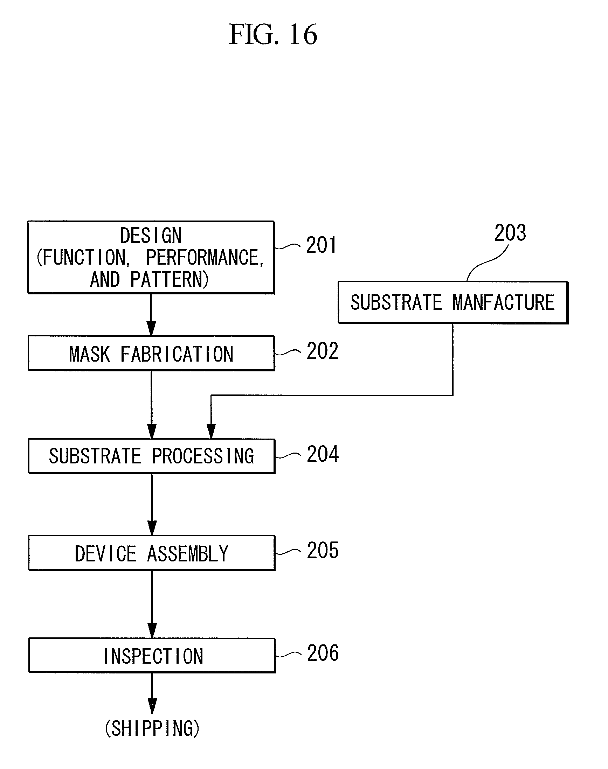

As shown in FIG. 16, microdevices such as semiconductor devices are manufactured by going through: a step 201 that designs the functions and performance of the microdevice; a step 202 that fabricates the mask (reticle) based on this design step; a step 203 that manufactures the substrate that serves as the base material of the device; a step 204 including substrate processing steps such as a process that exposes the pattern of the mask onto a substrate by means of the exposure apparatus EX of the aforementioned embodiments, a process for developing the exposed substrate, and a process for heating (curing) and etching the developed substrate; a device assembly step 205 (including treatment processes such as a dicing process, a bonding process, and a packaging process); and an inspection step 206, and so on.

## Claims

1. An exposure apparatus that exposes a substrate, comprising:
a first optical system having an optical element that separates incident exposure light into a first exposure light and a second exposure light and emits the first exposure light in a first direction and emits the second exposure light in a second direction that differs from the first direction; and
a second optical system that irradiates the second exposure light that is emitted from the optical element in the second direction onto the substrate together with the first exposure light that is emitted in the first direction.

2. An exposure apparatus according to claim 1, wherein the optical element has a predetermined surface that passes a portion of the incident exposure light to be emitted in the first direction, and reflects the remaining portion of the incident exposure light to be emitted in the second direction.

3. An exposure apparatus according to claim 2, wherein the optical element is a polarization separation optical element in which the predetermined surface is a polarization separation surface that separates the incident exposure light into the first exposure light of a first polarization state and the second exposure light of a second polarization state, and emits the first exposure light of the first polarization state in the first direction and emits the second exposure light of the second polarization state in the second direction.

4. An exposure apparatus according to claim 3, wherein the second optical system includes a first optical unit that converts the polarization state of the second exposure light of the second polarization state that is emitted in the second direction from the optical element to the first polarization state and makes the converted second optical light incident on the polarization separation surface.

5. An exposure apparatus according to claim 4, wherein
the second optical system further includes a second optical unit that converts to the second polarization state the polarization state of the second exposure light, which, after being converted to the first polarization state, passes through the polarization separation surface by being incident on the polarization separation surface, and makes the second exposure light of the second polarization state incident on the polarization separation surface, and
the polarization separation optical element emits in the first direction the incident second exposure light that is converted to the second polarization state by the second optical unit.

6. An exposure apparatus according to claim 5, wherein the position at which the second exposure light is incident on the polarization separation surface from the second optical unit is a position, or in the vicinity thereof, that is optically conjugate with a position at which the exposure light is incident on the polarization separation surface.

7. An exposure apparatus according to claim 2, wherein the second optical system includes a first optical unit that reverses the transmission and reflection characteristics of the second exposure light with respect to the predetermined surface.

8. An exposure apparatus according to any one of claims 2 to 7, wherein
the second optical system is attachable and detachable with respect to the first optical system; and
in the state of the second optical system not being attached, the optical element of the first optical system combines and emits exposure light from a first pattern that passes through the predetermined surface and exposure light from a second pattern that is reflected by the predetermined surface, and multiply exposes a predetermined field on the substrate with the combined exposure lights.

9. An exposure apparatus that exposes a substrate, the exposure apparatus:
provided with a first optical system having an optical element that is arranged at a position at which a plurality of exposure lights can be incident, with the substrate being irradiated by exposure light from the optical element; and
capable of selecting:
a first mode that singly exposes a predetermined field on the substrate with an image of a first pattern that is formed on a first exposure field by irradiating exposure light on the first exposure field via the first pattern and the optical element, and
a second mode that multiply exposes a predetermined field on the substrate with an image of the first pattern that is formed on the first exposure field by irradiating exposure light on the first exposure field via the first pattern and the optical element and with an image of a second pattern that is formed on a second exposure field by irradiating exposure light on the second exposure field via the second pattern and the optical element.

10. An exposure apparatus according to claim 9, wherein
the optical element includes a combining optical element that is capable of separating the plurality of exposure lights that are incident and combining the plurality of exposure lights that are incident, and
in the first mode, a second optical system that processes at least a portion of the separated exposure lights is arranged at a predetermined position with respect to the first optical system so that the exposure lights that are incident on the combining optical element from the first pattern and separated by the combining optical element are irradiated onto the substrate, and
in the second mode, the second optical system is removed from the first optical system, the exposure light from the first pattern and the exposure light from the second pattern are made incident on the combining optical element, the exposure light from the first pattern and the exposure light from the second pattern are combined by the combining optical element, and respectively irradiated on the first exposure field and the second exposure field.

11. An exposure apparatus according to claim 10, wherein
the combining optical element has a predetermined surface that passes a portion of the incident exposure light and reflects the remaining portion, and
the second optical system includes an optical unit that processes the exposure light that is emitted from the combining optical element in a direction not towards the substrate to direct it towards the substrate.

12. An exposure apparatus according to claim 11, wherein the optical unit of the second optical system adjusts the transmission and reflection characteristics with respect to the predetermined surface of the exposure light that is emitted from the combining optical element in the direction not towards the substrate.

13. An exposure apparatus according to claim 10, wherein the combining optical element includes a polarization separation optical element that passes exposure light of a first polarization state and reflects exposure light of a second polarization state, and has a polarization separation surface that separates the incident exposure light into exposure light of the first polarization state and exposure light of the second polarization state.

14. An exposure apparatus according to claim 13, wherein the second optical system converts the polarization state of the exposure light that is emitted in a direction not towards the substrate by being separated by the polarization separation surface and afterward makes the exposure light incident again on the polarization separation surface.

15. An exposure apparatus according to claim 13, wherein
in the first mode, the second optical system is arranged at a predetermined position with respect to the first optical system, and exposure light from the first pattern that includes at least a first polarization component and a second polarization component is made incident on the polarization separation optical element, and
in the second mode, the second optical system is removed from the first optical system, exposure light from the first pattern having one of the first polarization component and the second polarization component as a main component is made incident on the polarization separation optical element, and exposure light from the second pattern having the other of the first polarization component and the second polarization component as a main component is made incident on the polarization separation optical element.

16. An exposure apparatus according to claim 9, wherein
in the first mode, an optical element with no refracting power is arranged at a position at which a plurality of exposure lights can be incident, and
in the second mode, a combining optical element is arranged at a position at which a plurality of exposure lights can be incident, the combining optical element being capable of separating the plurality of exposure lights that are incident and capable of combining the plurality of exposure lights that are incident; the exposure light from the first pattern and the exposure light from the second pattern are made incident on the combining optical element; and the exposure light from the first pattern and the exposure light from the second pattern are combined by the combining optical element and respectively irradiated on the first exposure field and the second exposure field.

17. An exposure apparatus according to any one of claims 9 to 16, wherein
in the first mode, the predetermined field on the substrate is singly exposed while moving the predetermined field on the substrate in a predetermined scanning direction with respect to the first exposure field, and
in the second mode, the predetermined field on the substrate is multiply exposed while moving the predetermined field on the substrate in a predetermined scanning direction with respect to the first exposure field and the second exposure field.

18. An exposure apparatus according to any one of claims 9 to 17, wherein in the second mode, the predetermined field on the substrate is multiply exposed while moving the first pattern and the second pattern in predetermined scanning directions.

19. A device manufacturing method that uses the exposure apparatus according to any one of claims 1 to 18.
